# EUROPÄISCHE PATENTSCHRIFT

(11) **EP 4 488 703 B1**
(45) Veröffentlichungstag und Bekanntmachung des Hinweises auf die Patenterteilung: **09.09.2026**
(21) Anmeldenummer: 23183223.9
(22) Anmeldetag: 04.07.2023
(51) Int. Cl.: G01R 33/36, G01R 33/54

(54) **VERFAHREN ZUM ERMITTELN EINES OPTIMALEN ENERGIESPARZUSTANDS EINES MAGNET-RESONANZ-TOMOGRAPHIE SYSTEMS**
METHOD FOR DETERMINING AN OPTIMAL ENERGY SAVING STATE OF A MAGNETIC RESONANCE TOMOGRAPHY SYSTEM
PROCÉDÉ DE DÉTERMINATION D'UN ÉTAT OPTIMAL D'ÉCONOMIE D'ÉNERGIE D'UN SYSTÈME DE TOMOGRAPHIE PAR RÉSONANCE MAGNÉTIQUE

(43) Veröffentlichungstag der Anmeldung: 08.01.2025
(73) Patentinhaber: Siemens Healthineers AG, 91301 Forchheim (DE)
(72) Erfinder: Beck, Thomas, 91077 Dormitz (DE); Campagna, Swen, 91238 Engelthal (DE)
(74) Vertreter: Siemens Healthineers Patent Attorneys

(56) Entgegenhaltungen:
- DE-U1- 202021 102 582
- US-A1- 2016 161 581
- US-A1- 2022 244 332
- WOOLEN SEAN A. ET AL: "Ecodesign and Operational Strategies to Reduce the Carbon Footprint of MRI for Energy Cost Savings", RADIOLOGY, vol. 307, no. 4, 25 April 2023 (2023-04-25), US, pages 1 - 10, XP093104370, ISSN: 0033-8419, DOI: 10.1148/radiol.230441

## Beschreibung

Die vorliegende Erfindung betrifft ein Verfahren zum Ermitteln eines optimalen Energiesparzustands eines Magnet-Resonanz-Tomographie Systems, ein Magnet-Resonanz-Tomographie System, ein Computerprogrammprodukt und ein computerlesbares Speichermedium.

Der Energieverbrauch eines medizinischen Systems ist ein großer Faktor in den Betriebskosten des medizinischen Systems. Dies trifft insbesondere auf ein Magnet-Resonanz-Tomographie (Akronym: MRT) System zu. Der Energieverbrauch eines MRT-Systems kann signifikant reduziert werden, wenn es in einen Energiesparzustand bzw. Standby Zustand versetzt wird.

Ein MRT-System umfasst typischerweise eine Mehrzahl an Komponenten, beispielsweise einen Gradientenverstärker, einen Hochfrequenzverstärker, einen Patiententisch, einen Helium-Kompressor, ein Kühlsystem, ein Rechensystem, einen Generator für Verstimmströme, etc. Einzelne Komponenten des MRT-Systems können wiederum Sub-Komponenten, wie beispielsweisen einen Modulator etc. umfassen. Ein Energiesparzustand kann hergestellt werden, indem wenigstens eine Komponente oder eine Sub-Komponente des MRT-Systems heruntergefahren bzw. in einen Standby Zustand versetzt wird. Insbesondere kann dabei eine Komponente in verschiedene Standby Zustände versetzbar sein, von denen aus sie unterschiedlich schnell wieder aktivierbar ist.

Einige Komponenten eines MRT-Systems können schnell deaktiviert und wieder aktiviert werden. Mit dem Deaktivieren einer Komponente kann auch das Deaktivieren einer von der Komponente umfassten Sub-Komponente gemeint sein. Andere Komponenten eines MRT-Systems, wie beispielsweise die Kühlung oder die Stromversorgung hingegen benötigen eine längere Zeit, um heruntergefahren und insbesondere wieder aktiviert zu werden. Somit kann ein MRT-System verschiedene Energiesparzustände einnehmen, in Abhängigkeit davon, welche Komponenten des MRT-Systems heruntergefahren werden.

Welcher Energiesparzustand eingenommen wird, hängt davon ab, wie schnell das MRT-System wieder einsatzbereit sein soll. Beispielsweise im Regelbetrieb zwischen zwei Patienten soll das MRT-System schnellstmöglich wieder einsatzbereit sein, es wird also typischerweise keine Komponente oder nur eine schnell wieder aktivierbare Komponente heruntergefahren. Beispielsweise in der Nacht oder am Wochenende kann das MRT-System in einen "tieferen" Energiesparzustand versetzt werden, von welchem aus es länger dauert, bis das MRT-System wieder betriebsbereit ist. Je mehr Komponenten des MRT-Systems heruntergefahren werden, desto mehr Energie kann eingespart werden, desto länger kann es allerdings auch dauern, bis das MRT-System wieder einsatzbereit ist. Ebenso kann die Dauer, bis das MRT-System wieder einsatzbereit ist, von der Art bzw. Tiefe eines Standby-Zustands einer Komponente abhängen.

Es ist bekannt, ein MRT-System zeitgesteuert in einen bestimmten Energiesparzustand zu versetzen. Dabei wird das MRT-System zu vordefinierten Zeitpunkten in bestimmte Energiesparzustände versetzt. Beispielsweise kann das MRT-System immer abends zu einer bestimmten Zeit in den Nachtzustand, einen Energiesparzustand, von welchem aus es längere Zeit dauert, bis das MRT-System wieder betriebsbereit ist, versetzt werden.

Das zeitgesteuerte Vorgehen hat den Nachteil, dass es unflexibel ist. Kurzfristige ungenutzte Zeiten des MRT-Systems werden nicht erkannt und das MRT-System wird in diesen Fällen nicht in einen Energiesparzustand versetzt. Dadurch wird ein großes Einsparpotential nicht genutzt.

Außerdem ist bekannt, ein MRT-System ereignisgesteuert in einen bestimmten Energiesparzustand zu versetzen. Dafür kommunizieren die einzelnen Komponenten des MRT-Systems miteinander. Beispielsweise kann ein Gradientenverstärker des MRT-Systems mit einem Patiententisch des MRT-Systems kommunizieren. In Abhängigkeit einer Position des Patiententisches kann der Gradientenverstärker heruntergefahren werden. Dabei können wiederum einzelne Komponenten des Gradientenverstärkers heruntergefahren werden.

Das ereignisgesteuerte Vorgehen hat den Nachteil, dass die einzelnen Komponenten des MRT-Systems miteinander kommunizieren müssen. Ein Austausch einer defekten Komponente, beispielsweise des Patiententisches, kann es notwendig machen, auch eine andere Komponente, beispielsweise den Gradientenverstärker auszutauschen, da der alte Gradientenverstärker möglicherweise nicht mehr mit dem neuen Patiententisch kommunizieren kann und nicht mehr anhand der Positionen des Patiententisches erkennt, in welchen er in einen Energiesparzustand wechseln soll. Dies führt zu erhöhten Kosten, da auch nicht defekte Komponenten unter Umständen ausgetauscht werden müssen.

Außerdem ist bekannt, ein MRT-System manuell in einen Energiesparzustand zu versetzen.

Das manuelle Vorgehen hat den Nachteil, dass es rein von der subjektiven Einschätzung des Bedienpersonals abhängt. Zudem muss das Bedienpersonal das MRT-System und die verschiedenen Energiesparzustände gut kennen, um zu wissen, wann das MRT-System in welchen Energiesparzustand versetzt werden sollte. Außerdem wird für das manuelle Vorgehen Arbeitskraft und insbesondere Zeit von dem Bedienpersonal beansprucht. Das Bedienpersonal kann dabei insbesondere ein Radiologe bzw. eine Radiologin und/oder eine medizinisch-technische Radiologieassistenz (Akronym: MTRA) sein.

Aus dem Dokument US 2022/0244332 A1 ist ein intelligentes Steuersystem und Verfahren zum dynamischen Steuern von Komponenten eines MRT-Systems bekannt. Es bestimmt den aktuellen Nutzungszustands jeder Komponente und optimiert den Energieverbrauchs der Komponenten basierend auf dem aktuellen Nutzungszustand jeder Komponente, wodurch ein optimaler Energieverbrauch bereitgestellt wird. Das Steuersystem ändert das Energieverbrauchsprofil jeder Komponente basierend auf dem optimalen Energieverbrauch, sodass ein geänderter Energieverbrauch für jede Komponente bereitgestellt wird und aktiviert automatisch die Stromversorgung jeder Komponente basierend auf dem geänderten Energieverbrauch, wenn das MRT-System betrieben werden soll und deaktiviert automatisch die Stromversorgung jeder Komponente basierend auf dem geänderten Energieverbrauch, wenn das MRT-System nicht betrieben werden soll.

Das Dokument US2016161581A1 beschreibt ein Magnetresonanztomographiegerät und ein Verfahren zum Betreiben des MRT-Geräts. Das MRT-Gerät umfasst eine Überwachungseinheit, die zum Überwachen eines Betriebs des MRT-Geräts konfiguriert ist; und eine Steuereinheit, die zum Bestimmen eines von mehreren Leistungsmodi für das MRT-Gerät basierend auf dem überwachten Betrieb konfiguriert ist und das MRT-Gerät so steuert, dass es im bestimmten Leistungsmodus arbeitet.

Das Dokument DE 20 2021 102 582 U1 offenbart einen Magnetresonanztomographen, der einen Bewegungsmelder aufweist, der in Signalverbindung mit einer Steuerung des Magnetresonanztomographen steht und derart ausgerichtet ist, dass er eine Umgebung des Magnetresonanztomographen erfasst. Der Bewegungsmelder gibt ein Bewegungssignal über eine detektierte Bewegung in der Umgebung über die Signalverbindung an die Steuerung aus, und die Steuerung steuert in Abhängigkeit von dem Bewegungssignal einen Energiesparmodus des Magnetresonanztomographen.

Es ist daher die Aufgabe der vorliegenden Erfindung, ein Verfahren bereitzustellen, welches es ermöglicht, ein MRT-System in einen optimalen Energiesparzustand zu versetzen. Die Aufgabe wird gelöst durch ein Verfahren zum Ermitteln eines optimalen Energiesparzustands eines Magnet-Resonanz-Tomographie Systems, durch ein Magnet-Resonanz-Tomographie System, durch ein Computerprogrammprodukt und durch ein computerlesbares Speichermedium gemäß den unabhängigen Ansprüchen. Vorteilhafte Weiterbildungen sind in den abhängigen Ansprüchen und in der folgenden Beschreibung aufgeführt.

Nachstehend wird die erfindungsgemäße Lösung der Aufgabe sowohl in Bezug auf die beanspruchten Vorrichtungen als auch in Bezug auf das beanspruchte Verfahren beschrieben. Hierbei erwähnte Merkmale, Vorteile oder alternative Ausführungsformen sind ebenso auch auf die anderen beanspruchten Gegenstände zu übertragen und umgekehrt. Mit anderen Worten können die gegenständlichen Ansprüche (die beispielsweise auf eine Vorrichtung gerichtet sind) auch mit den Merkmalen, die in Zusammenhang mit einem Verfahren beschrieben oder beansprucht sind, weitergebildet sein. Die entsprechenden funktionalen Merkmale des Verfahrens werden dabei durch entsprechende gegenständliche Module ausgebildet. Weiterhin wird die erfindungsgemäße Lösung der Aufgabe sowohl in Bezug auf Verfahren und Vorrichtungen zum Ermitteln eines optimalen Energiesparzustands eines Magnet-Resonanz-Tomographie Systems als auch in Bezug auf Verfahren und Vorrichtungen zum Bereitstellen einer trainierten Funktion beschrieben. Hierbei können Merkmale und alternative Ausführungsformen von Datenstrukturen und/oder Funktionen bei Verfahren und Vorrichtungen zur Bestimmung auf analoge Datenstrukturen und/oder Funktionen bei Verfahren und Vorrichtungen zum Anpassen/Optimieren/Trainieren übertragen werden. Analoge Datenstrukturen können hierbei insbesondere durch die Verwendung der Vorsilbe "Trainings" gekennzeichnet sein. Weiterhin können die in Verfahren und Vorrichtungen zum Ermitteln eines optimalen Energiesparzustands eines Magnet-Resonanz-Tomographie Systems verwendeten trainierten Funktionen insbesondere durch Verfahren zum Bereitstellen der trainierten Funktion trainiert bzw. angepasst worden und/oder bereitgestellt worden sein.

Unabhängig vom grammatikalischen Geschlecht eines bestimmten Begriffes sind Personen mit männlicher, weiblicher oder anderer Geschlechteridentität mit umfasst.

Die Erfindung betrifft ein computerimplementiertes Verfahren zum Ermitteln eines optimalen Energiesparzustands eines Magnet-Resonanz-Tomographie (Akronym: MRT) Systems. Das Verfahren umfasst einen Verfahrensschritt eines Empfangens eines Regelsatzes mit einer zentralen Steuerung. Das Verfahren umfasst weiter einen Verfahrensschritt eines Empfangens von Zuständen von Komponenten mit der zentralen Steuerung. Die Komponenten sind dabei Komponenten des MRT-Systems und/oder einer Umgebung des MRT-Systems. Dabei umfasst der Regelsatz wenigstens eine Regel, mittels welcher basierend auf den Zuständen der Komponenten der optimale Energiesparzustand bestimmbar ist. Das Verfahren umfasst weiter einen Verfahrensschritt eines Bestimmens des optimalen Energiesparzustands basierend auf dem Regelsatz und den Zuständen der Komponenten. Das Verfahren umfasst weiter einen Verfahrensschritt eines Bereitstellens einer Information bezüglich des optimalen Energiesparzustands.

Das MRT-System ist dazu ausgebildet medizinische Bilddaten eines Patienten zu erfassen. Das MRT-System umfasst eine Mehrzahl an Komponenten, beispielsweise einen Gradientenverstärker, einen Hochfrequenzverstärker, einen Patiententisch, einen Helium-Kompressor, ein Kühlsystem, ein Rechensystem, einen Generator für Verstimmströme, ein Planungssystem etc. Einzelne Komponenten des MRT-Systems können wiederum Sub-Komponenten, wie beispielsweisen einen Modulator etc. umfassen. Ein Energiesparzustand kann hergestellt werden, indem Komponenten oder Sub-Komponenten des MRT-Systems heruntergefahren bzw. in einen Standby Zustand versetzt wird. Insbesondere kann eine Komponente bzw. eine Sub-Komponente in verschieden tiefe Standby-Zustände versetzbar sein. Je tiefer der Standby-Zustand ist, desto länger dauert eine Aktivierung der Komponente.

In dem Verfahrensschritt des Empfangens des Regelsatzes wird der Regelsatz mittels einer Schnittstelle der zentralen Steuerung empfangen. Die zentrale Steuerung kann dabei insbesondere von dem MRT-System umfasst sein. Der Regelsatz kann dabei insbesondere von einer Datenbank oder einem Cloud-System bereitgestellt werden. Alternativ kann der Regelsatz als Werkseinstellung in einem Speicher des MRT-Systems und/oder der zentralen Steuerung hinterlegt sein. Insbesondere kann dann beim Empfangen des Regelsatzes der Regelsatz von dem Speicher bereitgestellt werden.

In dem Verfahrensschritt des Empfangens von Zuständen von Komponenten, Zustände von Komponenten mittels der Schnittstelle der zentralen Steuerung empfangen. Die Komponenten sind dabei Komponenten des MRT-Systems. Zusätzlich kann eine Komponente eine Komponente einer Umgebung des MRT-Systems sein. Die Umgebung des MRT-Systems kann beispielsweise ein Raum sein, in welchem das MRT-System angeordnet ist. Dieser Raum wird im Folgenden als MRT Untersuchungsraum bezeichnet. Alternativ oder zusätzlich kann die Umgebung des MRT-Systems eine klinische Einrichtung sein, welche das MRT-System nutzt. Die klinische Einrichtung kann beispielsweise ein Krankenhaus oder eine Radiologie-Praxis oder eine Notaufnahme etc. sein. Die Komponente der Umgebung kann dabei beispielsweise ein Lichtschalter, eine Heizungsanlage, ein Notknopf, ein Eingangssignal aus einer Notaufnahme sein.

Wenn die Komponente der Patiententisch ist, kann der Zustand beispielsweise eine Position des Patiententisches angeben. Wenn die Komponente das Planungssystem ist, kann der Zustand beispielsweise eine Warteschlage von Patienten angeben. Mit anderen Worten kann der Zustand angeben, ob bereits ein oder mehrere Patienten für eine medizinische Bildgebung mit dem MRT-System erwartet wird. Alternativ oder zusätzlich kann der Zustand eine Protokollwarteschlange angeben. Die Protokollwarteschlange gibt dabei an, ob ein Protokoll in nächster Zeit ausgeführt werden soll. Dies kann insbesondere ein Indikator für eine geplante medizinische Bildgebung mit dem MRT-System sein. Wenn die Komponente der Gradientenverstärker ist, kann der Zustand angeben, welche Sub-Komponenten des Gradientenverstärkers gerade aktiv und welche in einem Energiesparzustand sind. Wenn die Komponente die Notaufnahme ist, kann der Zustand angeben, ob gerade ein Patient in die Notaufnahme aufgenommen wird, von welchem potenziell mit dem MRT-System eine medizinische Bildgebung gemacht werden soll.

Die zentrale Steuerung ist dazu ausgebildet mit den Komponenten des MRT-Systems zu kommunizieren. Mit anderen Worten hat die zentrale Steuerung mindestens eine Schnittstelle mit den Komponenten des MRT-Systems. Die zentrale Steuerung kann außerdem dazu ausgebildet sein, mit Komponenten aus der Umgebung des MRT-Systems zu kommunizieren. Mit anderen Worten kann die zentrale Steuerung eine Schnittstelle mit Komponenten aus der Umgebung des MRT-Systems aufweisen.

Der Regelsatz umfasst dabei wenigstens eine Regel. Die wenigstens eine Regel gibt den optimalen Energiesparzustand in Abhängigkeit Zuständen der Komponenten vor. Mit anderen Worten kann basierend auf dem Regelsatz ausgehend von den Zuständen der Komponenten der optimale Energiesparzustand abgeleitet werden. Mit anderen Worten ist basierend auf dem Regelsatz ausgehend von dem Zustand der Komponenten der optimale Energiesparzustand bestimmbar.

Der optimale Energiesparzustand ist dabei derart ausgebildet, dass eine maximale Energieeinsparung unter Berücksichtigung der benötigten Aktivierungszeit erzielt wird. Vorteilhafterweise kann der optimale Energiesparzustand durch die maximale Aktivierungszeit definiert werden. Die maximale Aktivierungszeit gibt dabei vor, wie schnell das MRT-System für eine medizinische Bildgebung bereit sein muss. Die maximale Aktivierungszeit kann insbesondere von den Zuständen der Komponenten abgeleitet werden. Je länger die maximale Aktivierungszeit ist, desto mehr Komponenten des MRT-Systems können heruntergefahren bzw. deaktiviert und/oder in einen Standby-Zustand bzw. in einen Energiesparzustand versetzt werden. Je länger die maximale Aktivierungszeit ist, desto "tiefer" können die gewählten Standby-Zustände sein. Alternativ kann der optimale Energiesparzustand auch der Betriebszustand des MRT-Systems sein. Der Betriebszustand ist der Zustand, in welchem das MRT-System jederzeit einsatzbereit ist. Insbesondere ist im Betriebszustand keine der Komponenten des MRT-Systems deaktiviert oder in einem Standby-Zustand.

Der Regelsatz kann somit einen Zusammenhang zwischen den Zuständen der Komponenten und einer maximalen Aktivierungszeit umfassen. Alternativ kann der Regelsatz einen Zusammenhang zwischen den Zuständen der Komponenten und einer Information darüber welche Komponenten in welchen Energiesparzustand versetzt werden sollen umfassen.

Wenn beispielsweise ein Lichtschalter in der Umgebung des MRT-Systems angemacht wird, kann dies eine Verkürzung der maximalen Aktivierungszeit bedeuten und der optimale Energiesparzustand des MRT-Systems ist dann ein Energiesparzustand, aus welchem das MRT-System schneller für eine medizinische Bildgebung bereit ist, als wenn der Lichtschalter aus ist. Analog kann bei einem Eingang eines Patienten in die Notaufnahme der optimale Energiesparzustand des MRT-Systems ein Energiesparzustand sein, aus welchem das MRT-System schneller für eine medizinische Bildgebung bereit ist, als wenn die Notaufnahme leer ist. Analog kann eine bestimmte Position des Patiententisches bedeuten, dass das MRT-System in einen Energiesparzustand versetzt werden kann. Diese und weitere Zusammenhänge bzw. Regeln können in dem Regelsatz vorgegeben sein.

Optional kann der optimale Energiesparzustand alternativ oder zusätzlich zu der Aktivierungszeit weitere Parameter berücksichtigen. Beispielsweise kann bei dem optimalen Energiesparzustand berücksichtigt werden, dass bestimmte Komponenten des MRT-Systems nicht beliebig häufig ein- und ausgeschaltet werden dürfen, um einen Verschleiß zu reduzieren. Der optimale Energiesparzustand berücksichtigt dabei, ob ein Ausschalten einer solchen Komponente noch sinnvoll ist, oder ob darauf verzichtet werden sollte, um den Verschleiß zu reduzieren. Eine solche Komponente ist beispielsweise der Kaltkopf. Alternativ kann es sinnvoll sein, bestimmte Komponenten nach einer bestimmten Zeit neu zu starten. Durch den Neustart dieser Komponenten können beispielsweise automatische Tests ausgeführt werden oder die entsprechenden Komponenten zurückgesetzt werden. Beim optimalen Energiesparzustand kann berücksichtigt werden, dass solche Komponenten bevorzugt heruntergefahren werden.

In dem Verfahrensschritt des Bestimmens des optimalen Energiesparzustands wird der optimale Energiesparzustand basierend auf dem Regelsatz und den Zuständen der Komponenten bestimmt.

In dem Verfahrensschritt des Bereitstellens der Information bezüglich des optimalen Energiesparzustands wird eine Information über den optimalen Energiesparzustand mittels der Schnittstelle bereitgestellt. Die Information kann dabei insbesondere angeben, wie dieser optimale Energiesparzustand hergestellt werden kann. Mit anderen Worten kann die Information angeben, wie das MRT-System in den optimalen Energiesparzustand versetzt werden kann.

Die Information wird derart bereitgestellt, dass die jeweiligen Komponenten bzw. Sub-Komponenten daraus ihren spezifischen optimalen Energiesparzustand ableiten können. Insbesondere ist die Information dabei generisch und von jeder der Komponenten bzw. Sub-Komponenten lesbar. Beispielsweise kann die Information eine maximale Aktivierungszeit umfassen. Basierend auf dieser maximalen Aktivierungszeit kann jede Komponente bzw. Sub-Komponente selbstständig entscheiden, welches der optimale Energiesparzustand für sie ist. Die maximale Aktivierungszeit kann beispielsweise in Sekunden, Minuten und/oder Stunden angegeben werden. Alternativ kann die maximale Aktivierungszeit in Kategorien angegeben werden. Die Kategorien können beispielsweise "schnell", "mittel" und "lang" umfassen. Eine alternative und insbesondere eine feinere Unterteilung der Kategorien ist möglich.

Die Information kann insbesondere einer Datenbank und/oder den entsprechenden Komponenten des MRT-Systems und/oder dem Bedienpersonal bereitgestellt werden. Wenn die Information dem Bedienpersonal bereitgestellt wird, kann die Information insbesondere mittels einer Anzeigeeinheit, beispielsweise einem Bildschirm bzw. einem Monitor bereitgestellt werden.

Die Erfinder haben erkannt, dass durch den Regelsatz und die zentrale Steuerung die einzelnen Komponenten des MRT-Systems nicht direkt miteinander kommunizieren müssen, um einen geeigneten Energiesparzustand des MRT-Systems zu ermitteln. Die zentrale Steuerung erlaubt es außerdem, dass auch der Zustand von Komponenten aus der Umgebung des MRT-Systems bei dem Bestimmen des optimalen Energiesparzustands berücksichtigt werden können. Insbesondere können mehr Komponenten des MRT-Systems und/oder aus der Umgebung des MRT-Systems berücksichtigt werden, als es bisher möglich war, da die zentrale Steuerung eine eins zu eins Kommunikation der Komponenten ersetzt und eine komplexere Berücksichtigung der verschiedenen Zustände von verschiedenen Komponenten ermöglicht. Außerdem können nachträglich, das heißt nach erstmaliger Inbetriebnahme des MRT-Systems ermöglichte Energiesparzustände einzelner Komponenten auf einfache Weise berücksichtigt und integriert werden. Auf diese Weise kann der optimale Energiesparzustand bestimmt werden, der eine maximale Energieeinsparung ermöglicht. Durch das Bereitstellen der Information bezüglich des optimalen Energiesparzustands in generischer Form, beispielsweise in Form der maximalen Aktivierungszeit, ist es möglich, dass jede Komponente selbstständig bestimmt, welcher Energiesparzustand für sie unter dieser Bedingung optimal ist. Bei einem Austausch einer Komponente kann somit die neue Komponente mit derselben generischen Information den für sie optimalen Energiesparzustand bestimmen und es müssen keine anderen Komponenten, insbesondere auch nicht der Regelsatz angepasst werden. Somit kann beispielsweise ohne weitere Änderungen die neue Komponente basierend auf der Information bezüglich des optimalen Energiesparzustands Energiesparzustände einnehmen, die unter Umständen mit der vorhergehenden Komponente nicht möglich waren. Außerdem erlaubt die Verwendung der zentralen Steuerung in Kombination mit einem Regelsatz insbesondere bei einem Defekt und/oder bei einem Update bzw. Upgrade, dass lediglich einzelne Komponenten ausgetauscht werden können und lediglich die Kompatibilität der ausgetauschten Komponenten mit der zentralen Steuerung sichergestellt werden muss. Dies führt zu einer Kosteneinsparung bei der Wartung des MRT-Systems.

Nach einem Aspekt der Erfindung umfasst das Verfahren einen Verfahrensschritt eines Versetzens des MRT-Systems in den optimalen Energiesparzustand basierend auf der bereitgestellten Information bezüglich des optimalen Energiesparzustands.

Das MRT-System wird dabei basierend auf der bereitgestellten Information in den optimalen Energiesparzustand versetzt. Dabei werden von dem MRT-System umfasste Komponenten deaktiviert bzw. heruntergefahren und/oder in einen Standby-Zustand bzw. Energiesparzustand versetzt. Alternativ oder zusätzlich werden dabei von dem MRT-System umfasste Komponenten aktiviert bzw. hochgefahren.

Der optimale Energiesparzustand kann insbesondere hergestellt werden, indem mehr als eine Komponente in einen gemäß dem Regelsatz vorgegebenen Zustand versetzt wird.

Zum Versetzen des MRT-Systems in den optimalen Energiesparzustand wird jeder Komponente die oben beschriebene Information bezüglich des optimalen Energiesparzustands bereitgestellt. Wenn die Information wie oben beschrieben erfindungsgemäss generisch ausgebildet ist, beispielsweise die maximale Aktivierungszeit umfasst, kann jede Komponente selbstständig bestimmen, was der für sie optimale Energiesparzustand unter dieser Bedingung ist. Mit anderen Worten kann jede Komponente dann selbstständig bestimmen, ob bzw. in welchen Energiesparzustand sie sich versetzt.

Alternativ, jedoch nicht erfindungsgemäss, kann das MRT-System in den optimalen Energiesparzustand versetzt werden, indem die Information angibt, welche Komponenten in welchen Energiesparzustand versetzt werden sollen, um den optimalen Energiesparzustand des MRT-Systems herzustellen.

Die Erfinder haben erkannt, dass mit dem beschriebenen Verfahren das MRT-System in den optimalen Energiesparzustand versetzt werden kann. Auf diese Weise können die Betriebskosten des MRT-Systems reduziert werden. Zudem kann die Nachhaltigkeit des MRT-Systems verbessert werden, da durch die eingesparte Energie weniger Ressourcen verbraucht werden, und insbesondere weniger Treibhausgase ausgestoßen werden. Insbesondere können die Komponenten selbst basierend auf der von der Information vorgegebenen Bedingung bestimmen, welcher Energiesparzustand für sie optimal ist. Auf diese Weise müssen die einzelnen Komponenten lediglich die Information bezüglich des Energiesparzustands verstehen. Es ist nicht mehr notwendig, dass die einzelnen Komponenten miteinander kommunizieren und/oder, dass eine zentrale Einheit, insbesondere die zentrale Steuerung, für jede Komponente die möglichen Energiesparzustände kennt und den optimalen auswählt. Dies macht eine Wartung und einen Wechseln von Komponenten leichter und kostengünstiger.

Nach einem weiteren Aspekt der Erfindung wird das Verfahren durch einen zeitlichen Trigger initiiert. Alternativ oder zusätzlich wird das Verfahren durch eine Zustandsänderung der Zustände der Komponenten initiiert. Alternativ oder zusätzlich wird das Verfahren durch Empfangen einer Nutzereingabe initiiert.

Wenn das Verfahren durch einen zeitlichen Trigger initiiert wird, wird insbesondere zu wenigstens einen bestimmten Zeitpunkt und/oder in bestimmten Zeitintervallen der Zustände der Komponenten abgerufen bzw. empfangen und basierend auf dem aktuellen Zustand wie oben beschrieben der optimale Energiesparzustand erneut bestimmt.

Wenn das Verfahren durch eine Zustandsänderung der Komponenten initiiert wird, wird bei einer Änderung des Zustands der Komponenten das Verfahren initiiert. Insbesondere wird dann bei einer Änderung der Zustände der Komponenten der optimale Energiesparzustand für den geänderten Zustand bestimmt.

Wenn das Verfahren durch eine Nutzereingabe initiiert wird, kann ein Nutzer, insbesondere das Bedienpersonal das Bestimmen des optimalen Energiesparzustands initiieren. Die Nutzereingabe kann dabei insbesondere mittels eines Eingabemittels empfangen werden. Das Eingabemittel kann dabei eine Tastatur und/oder ein berührungsempfindlicher Bildschirm (engl.: Touchscreen) und/oder eine Computer-Maus sein.

Insbesondere kann das Verfahren durch jede der drei vorgenannten Optionen initiiert werden.

Der Erfinder hat erkannt, dass durch das zeitgesteuerte Initiieren sichergestellt wird, dass in regelmäßigen Abständen überprüft wird, ob der aktuelle Energiesparzustand, bzw. der aktuelle Zustand des MRT-Systems noch dem optimalen Energiesparzustand entspricht. Dabei kann der aktuelle Zustand des MRT-Systems auch der Betriebszustand sein. Der Erfinder hat erkannt, dass das durch eine Zustandsänderung initiierte Verfahren sicherstellt, dass der eingestellte Zustand des MRT-Systems auch nach einer Zustandsänderung noch dem optimalen Energiesparzustand entspricht. Der Erfinder hat erkannt, dass das manuelle Initiieren ermöglicht, das der optimale Energiesparzustand insbesondere dann ermittelt bzw. bestimmt wird, wenn ein Nutzer, insbesondere das Bedienpersonal dies für notwendig erachtet.

Nach einem weiteren Aspekt der Erfindung ist die Regel in Abhängigkeit einer Zugriffsberechtigung anpassbar.

Die Zugriffsberechtigung gibt an, wer berechtigt ist, den Regelsatz und insbesondere die von diesem Regelsatz umfasste Regel anzupassen bzw. zu verändern.

Insbesondere kann die wenigstens eine Regel nur von einem Hersteller des MRT-Systems anpassbar sein. Dann kann die Zugriffsberechtigung derart ausgebildet sein, dass nur der Hersteller die wenigstens eine Regel anpassen kann.

Alternativ oder zusätzlich kann die Zugriffsberechtigung einem Bedienpersonal die Berechtigung geben, die wenigstens eine Regel anzupassen.

Das Anpassen kann dabei ein Aktivieren oder Deaktivieren einer Regel umfassen. Alternativ kann das Anpassen ein inhaltliches Anpassen einer Regel umfassen. Bei einem inhaltlichen Anpassen können beispielsweise die Komponenten, die heruntergefahren werden sollen angepasst werden. Alternativ oder zusätzlich können bei einem inhaltlichen Anpassen wenigstens eines Parameters, der die Zustände der Komponenten beschreibt, bei dem die entsprechende Regel ausgeführt werden soll, angepasst werden. Der Parameter kann beispielsweise eine Koordinate einer Position des Patiententisches sein. Alternativ kann das Anpassen ein Löschen der Regel sein.

Alternativ kann die Zugriffsberechtigung ein Anpassen der Regel verbieten.

Insbesondere kann der Regelsatz mehr als eine Regel umfassen. Insbesondere kann das Anpassen verschiedener Regeln durch verschiedene Zugriffsberechtigungen geregelt sein. Dabei kann beispielsweise eine Regel nur durch den Hersteller anpassbar sein, eine weitere Regeln kann nur durch das Bedienpersonal anpassbar sein, eine weitere Regel kann durch den Hersteller und das Bedienpersonal anpassbar sein.

Der Erfinder hat erkannt, dass auf diese Weise sichergestellt werden kann, dass notwendige Regeln nicht oder nur durch den Hersteller angepasst werden können. Der Erfinder hat außerdem erkannt, dass durch die Zugriffsberechtigung dem Nutzer, insbesondere dem Bedienpersonal, die Möglichkeit bereitgestellt werden kann, einzelne Regeln des Regelsatzes nach seinen Bedürfnissen anzupassen. Der Erfinder hat erkannt, dass auf diese Weise dem Bedienpersonal die Möglichkeit des Anpassens des Regelsatzes bereitgestellt werden kann, unter der Bedingung, dass notwendige Regeln nicht oder nur durch den Hersteller anpassbar sind und somit eine Funktionsweise und ein bestimmtes Energiesparverhalten des MRT-Systems vorgegeben und sichergestellt werden kann.

Nach einem optionalen Aspekt der Erfindung ist der Regelsatz in Abhängigkeit einer Zugriffsberechtigung anpassbar.

Die Zugriffsberechtigung kann dabei wie oben beschrieben ausgebildet sein.

Der Regelsatz kann dabei durch ein Anpassen und/oder Löschen einer bestehenden Regel und/oder durch ein Hinzufügen einer neuen Regel angepasst werden. Das Anpassen des Regelsatzes kann dabei ebenfalls durch die Zugriffsberechtigung geregelt sein. Die Zugriffsberechtigung kann dabei in Abhängigkeit der Regel verschieden sein.

Die Erfinder haben erkannt, dass durch die Zugriffsberechtigung geregelt werden kann, wer den Regelsatz ändern darf, insbesondere wer eine Regel hinzufügen und/oder löschen darf.

Nach einem weiteren Aspekt der Erfindung umfasst das Verfahren außerdem einen Verfahrensschritt eines Empfangens einer optionalen Nutzereingabe bezüglich des optimalen Energiesparzustands mit der zentralen Steuerung. Dabei wird beim Bereitstellen der Information zu dem optimalen Energiesparzustand die Information bezüglich dem mittels der Nutzereingabe bereitgestellten optimalen Energiesparzustand bereitgestellt, sofern eine Nutzereingabe empfangen wurde.

In dem Verfahrensschritt des Empfangens der Nutzereingabe wird die Nutzereingabe mit der Schnittstelle der zentralen Steuerung empfangen, wenn eine Nutzereingabe bereitgestellt wird. Die Nutzereingabe ist dabei optional. Mit anderen Worten kann die Nutzereingabe durch einen Nutzer, insbesondere durch das Bedienpersonal bereitgestellt werden. Dann wird der optimale Energiesparzustand als der Energiesparzustand, der durch die Nutzereingabe bereitgestellt wurde, bestimmt. Wenn keine Nutzereingabe empfangen wird, wird der optimale Energiesparzustand wie oben beschrieben basierend auf dem Regelsatz und den Zuständen der Komponenten bestimmt. Mit anderen Worten kann also die Nutzereingabe, sofern sie bereitgestellt wird, den wie oben beschriebenen optimalen Energiesparzustand überschreiben.

Die Nutzereingabe kann insbesondere den optimalen Energiesparzustand generisch, beispielsweise in Form einer maximalen Aktivierungszeit vorgeben. Alternativ kann die Nutzereingabe vorgeben welche Komponenten in welchen Energiesparzustand versetzt werden sollen.

Die Schnittstelle, mit welcher die Nutzereingabe empfangen wird, kann insbesondere eine Tastatur und/oder ein berührungsempfindlicher Bildschirm (engl. Touchscreen) und/oder eine Computermaus und/oder eine Spracheingabe, beispielsweise ein Mikrophon, sein.

Die Erfinder haben erkannt, dass durch das optionale Empfangen einer Nutzereingabe sichergestellt werden kann, dass der Nutzer jederzeit frei entscheiden kann, in welchen Energiesparzustand das MRT-System versetzt werden soll. Insbesondere kann ein Nutzer auf diese Weise verhindern, dass das MRT-System in einen Energiesparzustand versetzt wird oder dass es in einen ungewünschten Energiesparzustand versetzt wird, aus welchem es eine relativ lange Zeit benötigt, bis es wieder einsatzbereit ist. Auf diese Weise kann berücksichtigt werden, dass der Nutzer möglicherweise bereits im Vorfeld weiß, wann ein Patient kommt bzw. dass noch ein Patient kommt. Insbesondere kann der Nutzer bei einem Notfall verhindern, dass das MRT-System in einen Energiesparzustand versetzt wird und auf diese Weise sicherstellen, dass das MRT-System jederzeit für diesen Notfall einsatzbereit ist. Oder der Nutzer kann einen anderen Energiesparzustand vorgeben, aus welchem das MRT-System beispielsweise schneller wieder einsatzbereit ist.

Nach einem weiteren Aspekt der Erfindung umfasst das Verfahren einen Verfahrensschritt eines Empfangens einer Zeitinformation mit der zentralen Steuerung. Dabei umfasst der Regelsatz außerdem eine Regel bezüglich der Zeitinformation. Dabei wird beim Bestimmen des optimalen Energiesparzustands die Regel bezüglich der Zeitinformation berücksichtigt.

Die Zeitinformation kann dabei insbesondere eine Uhrzeit umfassen. Die Zeitinformation kann außerdem ein Datum umfassen. Die Regel bezüglich der Zeitinformation kann dabei angeben, dass das MRT-System bei einer bestimmten Zeitinformation in einen bestimmten optimalen Energiesparzustand versetzt werden soll. Beispielsweise kann die Regel vorgeben, dass jeden Abend beispielsweise um 22Uhr das MRT-System für beispielsweise sieben Stunden in einen optimalen Energiesparzustand versetzt wird, aus dem es relativ lange dauert, das MRT-System wieder zu aktivieren. Alternativ oder zusätzlich kann die Regel vorgeben, dass das MRT-System außerdem jeden Freitag beispielsweise um 22 Uhr für beispielsweise 55 Stunden in diesen optimalen Energiesparzustand versetzt wird.

Alternativ oder zusätzlich kann die Zeitinformation ein Zeitintervall seit einer letzten Zustandsänderung einer der Komponenten umfassen. Die wenigstens eine Regel bezüglich der Zeitinformation des Regelsatzes kann dann vorgeben, dass wenn das Zeitintervall eine bestimmte Zeitdauer überschreitet, das MRT-System in einen optimalen Energiesparzustand versetzt wird.

Die Erfinder haben erkannt, dass das oben beschriebene Verfahren mit dem zeitgesteuerten Verfahren kombinierbar ist. Die Erfinder haben erkannt, dass dies in dem Regelsatz berücksichtigt werden kann. Die Erfinder haben erkannt, dass auf diese Weise der Vorteil einer Nachtabschaltung und/oder einer Wochenendabschaltung des MRT-Systems beibehalten werden kann.

Nach einem weiteren Aspekt der Erfindung umfasst der Regelsatz eine trainierte Funktion. Dabei wird beim Bestimmen des optimalen Energiesparzustands die trainierte Funktion auf den Zuständen der Komponenten angewendet. Dabei wird der optimale Energiesparzustand bestimmt.

In dem Verfahrensschritt des Anwendens der trainierten Funktion werden mittels der ersten trainierten Funktion basierend auf den Eingangsdaten die Ausgangsdaten erzeugt.

Im Allgemeinen ahmt eine trainierte Funktion kognitive Funktionen nach, die Menschen mit menschlichem Denken verbinden. Insbesondere durch auf Trainingsdaten basierendem Training kann sich die trainierte Funktion an neue Umstände anpassen sowie Muster erkennen und extrapolieren.

Im Allgemeinen können Parameter einer trainierten Funktion mittels Trainings angepasst werden. Insbesondere kann dafür ein beaufsichtigtes (supervised) Training, ein halbüberwachtes (semi-supervised) Training, ein unbeaufsichtigtes (unsupervised) Training, ein verstärkendes Lernen (reinforcement learning) und/oder ein aktives Lernen (active learning) verwendet werden. Darüber hinaus kann Repräsentationslernen (ein alternativer Begriff ist "Merkmalslernen") (representation learning bzw. feature learning) verwendet werden. Insbesondere können die Parameter der trainierten Funktionen durch mehrere Trainingsschritte iterativ angepasst werden.

Insbesondere kann eine trainierte Funktion ein neuronales Netzwerk, eine Unterstützungsvektormaschine (support vector machine), einen Zufallsbaum bzw. einen Entscheidungsbaum (decision tree) und/oder ein Bayes'sches Netzwerk umfassen, und/oder die trainierte Funktion kann auf k-Mittel-Clustering (k-means clustering), Q-Learning, genetischen Algorithmen und/oder Assoziationsregeln basieren. Insbesondere kann eine trainierte Funktion eine Kombination aus mehreren unkorrelierten Entscheidungsbäumen bzw. ein Ensemble aus Entscheidungsbäumen (random forest) umfassen. Insbesondere kann die trainierte Funktion mittels XGBoosting (extreme Gradient Boosting) bestimmt werden. Insbesondere kann ein neuronales Netzwerk ein tiefes neuronales Netzwerk (deep neural network), ein Faltungs-neuronales Netzwerk (convolutional neural network) oder ein Faltungs-tiefes neuronales Netzwerk (convolutional deep neural network) sein. Darüber hinaus kann ein neuronales Netzwerk ein kontradiktorisches Netzwerk (adversarial network), ein tiefes kontradiktorisches Netzwerk (deep adversarial network) und/oder ein generatives kontradiktorisches Netzwerk (generative adversarial network) sein. Insbesondere kann ein neuronales Netzwerk ein rekurrentes neuronales Netzwerk (recurrent neural network) sein. Insbesondere kann ein rekurrentes neuronales Netzwerk ein Netzwerk mit langem Kurzzeitgedächtnis (long-short-term-memory, LSTM), insbesondere eine Gated Recurrent Unit (GRU), sein. Insbesondere kann eine trainierte Funktion eine Kombination der beschriebenen Ansätze umfassen. Insbesondere werden die hier beschriebenen Ansätze für eine trainierte Funktion Netzwerkarchitektur der trainierten Funktion genannt.

Die trainierte Funktion gibt somit den Regelsatz vor bzw. umfasst den Regelsatz.

Die Erfinder haben erkannt, dass der Regelsatz durch eine trainierte Funktion realisiert bzw. dargestellt bzw. vorgegeben werden kann. Die Erfinder haben erkannt, dass auf diese Weise der Regelsatz besonders gut an die Bedürfnisse der Nutzer bzw. der Bedienpersonals anpassbar ist.

Nach einem weiteren Aspekt der Erfindung sind die Komponenten aus der Menge der folgenden Komponenten: ein Patiententisch, ein Rechensystem des MRT-Systems, ein Planungssystem, ein Notfalleingang, ein MRT Untersuchungsraum.

Der Zustand gibt dabei insbesondere einen Status der Komponenten an.

Der Patiententisch ist dabei dazu ausgebildet, einen Patienten während einer medizinischen Bildgebung mit dem MRT-System zu lagern. Der Patiententisch kann dabei verschiedene Positionen einnehmen. Insbesondere kann der Patiententisch eine Ausgangsposition bzw. Ruheposition einnehmen, wenn kein Patient auf dem Patiententisch gelagert ist. Der Zustand des Patiententisches beschreibt dabei die Position des Patiententisches.

Das Rechensystem kann dabei insbesondere einen Status und damit einen Zustand des MRT-Systems beschreiben. Beispielsweise kann das Rechensystem angeben, ob das MRT-System gerade in Benutzung bzw. aktiv ist. Insbesondere kann das Rechensystem angeben, ob das Rechensystem aktuell in einem Energiesparzustand ist und wenn ja, in welchem.

Das Planungssystem ist zur Untersuchungsplanung ausgebildet. Insbesondere kann das Planungssystem eine Warteschlange von Patienten umfassen. Mit anderen Worten kann das Bedienpersonal in dem Planungssystem angeben, von welchem Patient, wann mit dem MRT-System eine medizinische Bildgebung durchgeführt werden soll. Der Zustand des Planungssystems kann dabei angeben, ob wenigstens ein Patient in der Warteschlange aufgeführt ist. Das Planungssystem kann alternativ oder zusätzlich eine Protokollwarteschlange umfassen. Die Protokollwarteschlange kann dabei angeben, welche bzw. welches Protokoll als nächstes und zu welchem Zeitpunkt ausgeführt werden soll. Die Protokollwarteschlange kann dabei mit der Warteschlange der Patienten korreliert sein. Korreliert bedeutet in diesem Fall, dass für jeden Patienten in der Warteschlange wenigstens ein Protokoll in der Protokollwarteschlange aufgeführt ist. Der Zustand des Planungssystems kann dabei angeben, ob wenigstens ein Protokoll in der Protokollwarteschlange aufgeführt bzw. von dieser umfasst ist.

Der Notfalleingang kann von einer Notaufnahme umfasst sein. Der Zustand des Notfalleingangs kann dabei angeben, ob ein Patient in der Notaufnahme ist. Insbesondere kann der Zustand des Notfalleingangs angeben, ob ein Patient, welcher potentiell eine medizinische Bildgebung mit dem MRT-System benötigt in der Notaufnahme ist.

Der MRT Untersuchungsraum kann insbesondere wenigstens eine Sub-Komponente umfassen. Beispielsweise kann ein Lichtschalter und/oder ein Heizungssystem eine der Sub-Komponenten des MRT Untersuchungsraums sein. Der Zustand des MRT Untersuchungsraums kann dabei insbesondere angeben, ob der Lichtschalter an oder aus ist. Alternativ oder zusätzlich kann der Zustand des Untersuchungsraums angeben, ob das Heizungssystem an oder aus ist bzw. auf welcher Temperatur das Heizungssystem eingestellt ist.

Die Erfinder haben erkannt, dass insbesondere die Zustände dieser Komponenten berücksichtigt werden können, wenn der optimale Energiesparzustand bestimmt wird. Die Erfinder haben erkannt, dass anhand der Zustände dieser Komponenten frühzeitig und zuverlässig erkannt werden kann, wenn das MRT-System zeitnah benötigt wird bzw. wenn das MRT-System nicht benötigt wird.

Ein Aspekt betrifft außerdem ein computerimplementiertes Verfahren zum Bereitstellen einer trainierten Funktion. Das Verfahren umfasst einen Verfahrensschritt eines Empfangens wenigstens eines Zustands wenigstens einer Komponente. Das Verfahren umfasst außerdem einen Verfahrensschritt eines Empfangens einer Information bezüglich eines optimalen Energiesparzustands. Dabei hängt die Information bezüglich des optimalen Energiesparzustands von dem wenigstens einen Zustand der wenigstens einen Komponente ab. Das Verfahren umfasst außerdem einen Verfahrensschritt eines Trainierens einer Funktion basierend auf dem wenigstens einen Zustand der wenigstens einen Komponente und der Information des optimalen Energiesparzustands. Das Verfahren umfasst außerdem einen Verfahrensschritt eines Bereitstellens der trainierten Funktion.

Der wenigstens eine Zustand der wenigstens einen Komponente ist dabei insbesondere wie oben beschrieben ausgebildet. Dabei ist die Information bezüglich des optimalen Energiesparzustands insbesondere wie oben beschrieben ausgebildet.

In einem ersten Schritt kann der optimale Energiesparzustand basierend auf einem festen Regelsatz in Abhängigkeit von dem wenigstens einen Zustand der wenigstens einen Komponente vorgegeben sein. Mit anderen Worten kann in einem ersten Schritt für den wenigstens einen Zustand der wenigstens einen Komponente eine von einem festen Regelsatz umfassten Regel ein optimaler Energiesparzustand vorgegeben sein. Der Regelsatz und insbesondere die wenigstens eine Regel sind dabei wie oben beschrieben ausgebildet.

Dabei kann der optimale Energiesparzustand für den wenigstens einen Zustand der wenigstens einen Komponente in dem Verfahrensschritt des Empfangens des optimalen Energiesparzustands von einer Datenbank abgerufen werden.

Optional kann alternativ oder zusätzlich der optimale Energiesparzustand durch eine Nutzereingabe bereitgestellt werden. Insbesondere kann dabei die Nutzereingabe den optimalen Energiesparzustand bezüglich des wenigstens einen Zustands der wenigstens einen Komponente vorgeben. Wenn die Nutzereingabe zusätzlich zu dem optimalen Energiesparzustand basierend auf einem festen Regelsatz bereitgestellt wird, überschreibt die Nutzereingabe den optimalen Energiesparzustand basierend auf dem festen Regelsatz. Mit anderen Worten wird das weitere Verfahren dann basierend auf dem durch die Nutzereingabe bereitgestellten optimalen Energiesparzustand fortgesetzt.

Die Nutzereingabe kann insbesondere durch eine Eingabe durch das Bedienpersonal bereitgestellt werden. Die Nutzereingabe kann durch eine Eingabeeinheit empfangen werden. Die Eingabeeinheit kann beispielsweise eine Tastatur, ein berührungsempfindlicher Bildschirm (engl. Touchscreen) und/oder eine Computermaus sein.

Optional kann die Nutzereingabe nur dann empfangen werden, wenn eine Zugriffsberechtigung eine manuelle Bereitstellung des optimalen Energiesparzustands durch eine Nutzereingabe erlaubt.

Optional kann die Nutzereingabe auch jede beliebige Aktivität eines Bedienpersonals an dem MRT-System und/oder in der Umgebung des MRT-Systems umfassen. Insbesondere kann die Nutzereingabe beispielsweise ein Tastendruck und/oder einen Türkontakt und/oder eine Eingabe des Bedienpersonals mittels eines Eingabevorrichtung, beispielsweise mittels eine berührungsempfindlichen Bildschirms (engl. Touchpad bzw. Touchpanel), und/oder eigenständige Zustandsänderungen einzelner Komponenten, beispielsweise eines Kühlsystems, und/oder Änderungen in einem Computersystem, beispielsweise in einem Radiologie-Informations-System, und/oder eine Änderung in der Umgebung des MRT-Systems umfassen. Insbesondere können auf diese Weise Ereignisse, die ein Versetzen in einen Energiesparzustand auslösen, gelernt bzw. erkannt werden.

In dem Verfahrensschritt des Trainierens der Funktion wird die Funktion auf den wenigstens einen Zustand der wenigstens einen Funktion angewendet. Dabei wird ein Trainings-Energiesparzustand bestimmt. Dieser Trainings-Energiesparzustand wird mit dem empfangenen optimalen Energiesparzustand verglichen. Wenn der Trainings-Energiesparzustand von dem empfangene optimalen Energiesparzustand abweicht, wird wenigstens ein Parameter der Funktion variiert. Dabei wird der wenigstens eine Parameter derart variiert, dass bei einem erneuten Anwenden der derart variierten Funktion auf den wenigstens einen Zustand der wenigstens einen Komponente der Trainings-Energiesparzustand dem empfangenen optimalen Energiesparzustand besser entspricht. Dies wird so lange iterativ wiederholt, bis bei einem Anwenden der variierten Funktion auf den wenigstens einen Zustand der wenigstens einen Komponente der Trainings-Energiesparzustand dem empfangenen optimalen Energiesparzustand entspricht. Die variierte Funktion ist dann die trainierte Funktion.

Beim Trainieren kann die Funktion insbesondere wie beschrieben basierend auf einer Vielzahl von Zuständen einer Vielzahl von Komponenten und einer zugehörigen Vielzahl von optimalen Energiesparzuständen trainiert werden.

Beim Bereitstellen der trainierten Funktion wird die trainierte Funktion derart bereitgestellt, dass sie in dem oben beschriebenen Verfahren verwendet werden kann. Insbesondere stellt die trainierte Funktion dann den Regelsatz für das oben beschriebene Verfahren dar bzw. umfasst diesen.

Die Erfinder haben erkannt, dass der Regelsatz mittels einer trainierten Funktion abgebildet bzw. dargestellt werden kann. Die Erfinder haben erkannt, dass durch das Anwenden der trainierten Funktion auf den wenigstens einen Zustand der wenigstens einen Komponente auf eine einfache und effiziente Weise der optimale Energiesparzustand bestimmt werden kann. Die Erfinder haben erkannt, dass die trainierte Funktion insbesondere mittels überwachten Lernens (engl.: supervised learning) trainiert werden kann. Die Erfinder haben erkannt, dass dies zumindest ein erster Schritt für das Training der trainierten Funktion ist.

Nach einem Aspekt der Erfindung basiert das Training auf einem dezentralen, verteilten Training.

Das dezentrale bzw. verteile Training wird auch als "federated learning" bezeichnet.

Insbesondere kann auf diese Weise die Funktion wie oben beschrieben dezentral trainiert werden. Bei einem dezentralen Training wird die Funktion in verschiedenen Institutionen, beispielsweise Krankenhäusern und/oder Radiologiepraxen, lokal trainiert. Die derart lokal trainierten Funktionen können dann zentral zu einer gemeinsamen trainierten Funktion zusammengeführt werden.

Bei dem lokalen, bzw. dezentralen Training kann der Empfangene optimale Energiesparzustand bezüglich wenigstens einem Zustand wenigstens einer Komponente lokal durch ein Bedienpersonal modifiziert bzw. vorgegeben sein. Mit anderen Worten kann in jeder Institution ein leicht abweichender Regelsatz vorliegen.

Die Erfinder haben erkannt, dass auf diese Weise Vorlieben von verschiedenem Bedienpersonal verschiedener Institutionen bei der trainierten Funktion berücksichtigt werden können. Die Erfinder haben erkannt, dass durch das dezentrale, verteilte Training keine Daten nach außerhalb der Institution übertragen werden müssen. Dies kann insbesondere ein Risiko eines Datenlecks für die einzelnen Institutionen minimieren.

Nach einem weiteren Aspekt der Erfindung erfolgt das Trainieren kontinuierlich während des Ausführens des oben beschriebenen Verfahrens. Dabei ist der empfangene optimale Energiesparzustand der mit dem oben beschriebenen Verfahren bestimmte optimale Energiesparzustand. Dabei umfasst das Verfahren zum Bereitstellen der trainierten Funktion außerdem einen Verfahrensschritt eines Empfangens einer Information über einen Grad mit dem die trainierte Funktion kontinuierlich weiter trainiert werden soll. Dabei wird beim Trainieren der Funktion der Grad berücksichtigt.

Beim kontinuierlichen Training wird die trainierte Funktion auch während der Anwendung in dem oben beschriebenen Verfahren kontinuierlich weiter trainiert. Dabei kann der optimale Energiesparzustand wie oben beschrieben durch Anwenden der trainierten Funktion oder durch eine optionale Nutzereingabe oder durch eine Zeitinformation bestimmt werden.

Der Grad kann angeben, wie stark Änderungen bzw. Anpassungen des optimalen Energiesparzustands während der Anwendung, also insbesondere eine optionale Nutzereingabe beim kontinuierlichen Training berücksichtigt werden sollen. Insbesondere kann der Grad angeben, dass eine einmalige Anpassung nicht berücksichtigt werden soll. Insbesondere kann der Grad angeben, dass eine dauerhafte Änderung bzw. Anpassung berücksichtigt werden soll.

Die Erfinder haben erkannt, dass durch das Berücksichtigen der optionalen Nutzereingabe die trainierte Funktion personalisiert, d.h. speziell für eine Institution bzw. ein bestimmten Bedienpersonal nachtrainiert werden kann. Die Erfinder haben erkannt, dass durch den Grad beispielsweise vorgegeben werden kann, ob bereits eine einmalige Anpassung beim Trainieren berücksichtigt werden soll oder ob nur eine mehrmalige bzw. dauerhafte Anpassung berücksichtigt werden soll. Die Erfinder haben erkannt, dass auf diese Weise der Grad der Personalisierung der trainierten Funktion berücksichtigt werden kann.

Die Erfindung betrifft außerdem ein Magnet-Resonanz-Tomographie System gemäss Anspruch 9, umfassend eine zentrale Steuerung.

Die zentrale Steuerung ist eine zentrale Steuerung zum Ermitteln eines optimalen Energiesparzustands des MRT-Systems. Die zentrale Steuerung umfasst eine Schnittstelle und eine Recheneinheit.

Das Magnet-Resonanz-Tomographie (Akronym: MRT) System umfasst bevorzugt eine medizinische und/oder diagnostische Magnetresonanzvorrichtung, die zu einem Erfassen von medizinischen und/oder diagnostischen Bilddaten, insbesondere medizinischen und/oder diagnostischen MRT Bilddaten, eines Patienten ausgelegt und/oder ausgebildet ist. Die Magnetresonanzvorrichtung und damit das MRT-System sind somit zur medizinischen Bildgebung ausgebildet. Die Magnetresonanzvorrichtung umfasst hierzu eine Scannereinheit. Die Scannereinheit der Magnetresonanzvorrichtung umfasst bevorzugt eine Detektoreinheit, zur Erfassung der medizinischen und/oder diagnostischen Bilddaten. Vorteilhafterweise umfasst hierbei die Scannereinheit, insbesondere eine Magneteinheit der Scannereinheit, eine Körperspule (engl. Body Coil), einen Grundmagneten, eine Gradientenspuleneinheit und eine Hochfrequenzantenneneinheit.

Die Hochfrequenzantenneneinheit ist fest innerhalb der Scannereinheit angeordnet und zur Aussendung eines Anregungspulses ausgelegt und/oder ausgebildet. Zur Erfassung der Magnetresonanzsignale kann die Magnetresonanzvorrichtung lokale Hochfrequenzspulen bzw. Lokalspulen aufweisen, die um den zu untersuchenden Bereich des Patienten angeordnet werden.

Der Grundmagnet der Scannereinheit ist zur Erzeugung eines homogenen Grundmagnetfelds mit einer definierten und/oder bestimmten Magnetfeldstärke, wie beispielsweise mit einer definierten und/oder bestimmten Magnetfeldstärke von 3 T oder 1,5 T usw., ausgebildet. Insbesondere ist der Grundmagnet zur Erzeugung eines starken, konstanten und homogenen Grundmagnetfelds ausgebildet. Das homogene Grundmagnetfeld ist bevorzugt innerhalb des Patientenaufnahmebereichs der Magnetresonanzvorrichtung angeordnet und/oder vorzufinden. Die Gradientenspuleneinheit ist zu einer Erzeugung von Magnetfeldgradienten, die für eine Ortskodierung während einer Bildgebung verwendet werden, ausgebildet.

Der Patientenaufnahmebereich ist zu einer Aufnahme des Patienten, insbesondere des zu untersuchenden Bereichs des Patienten, für eine medizinische Magnetresonanzuntersuchung bzw. Untersuchung ausgelegt und/oder ausgebildet. Beispielsweise ist hierzu der Patientenaufnahmebereich zylinderförmig ausgebildet und/oder zylinderförmig von der Scannereinheit umgeben. Hierzu weist die Scannereinheit eine den Patientenaufnahmebereich zumindest teilweise umgebenden Umhausung der Gehäuseeinheit auf. Die den Patientenaufnahmebereich umgebende Umhausung kann hierbei auch einteilig und/oder einstückig mit der dem Patientenaufnahmebereich zugewandte Seite der Hochfrequenzantenneneinheit der Scannereinheit ausgebildet sein oder auch separat zur Hochfrequenzantenneneinheit der Scannereinheit ausgebildet sein.

Wenn der Patient in das MRT-System bzw. die Körperspule gefahren wird, wird er insbesondere in dem Patientenaufnahmebereich positioniert.

Innerhalb des Patientenaufnahmebereichs ist bevorzugt ein Field of View (FOV) und/oder ein Isozentrum der Magnetresonanzvorrichtung angeordnet. Das FOV umfasst bevorzugt einen Erfassungsbereich der Magnetresonanzvorrichtung, innerhalb dessen die Bedingungen für eine Erfassung von medizinischen Bilddaten, insbesondere MRT Bilddaten, vorliegen, wie beispielsweise ein homogenes Grundmagnetfeld. Das Isozentrum der Magnetresonanzvorrichtung umfasst bevorzugt den Bereich und/oder Punkt innerhalb der Magnetresonanzvorrichtung, der die optimalen und/oder idealen Bedingungen für die Erfassung von medizinischen Bilddaten, insbesondere Magnetresonanzbilddaten, aufweist. Insbesondere umfasst das Isozentrum den homogensten Magnetfeldbereich innerhalb der Magnetresonanzvorrichtung.

Die Patientenlagerungsvorrichtung ist zu einer Positionierung und/oder Lagerung des Patienten für eine Untersuchung ausgebildet. Die Patientenlagerungsvorrichtung umfasst dabei den Patiententisch, der in den Patientenaufnahmebereich einfahrbar ausgebildet ist. Für eine Magnetresonanzuntersuchung wird der Patient derart auf dem Patiententisch positioniert, dass der zu untersuchende Bereich nach einem Positionieren bzw. Verfahren des Patiententischs entlang des Verfahrwegs innerhalb des Patientenaufnahmebereichs innerhalb des Isozentrums des Patientenaufnahmebereichs angeordnet und/oder positioniert ist.

Für eine Kommunikation und/oder eines Informationsaustauschs des Patienten mit dem medizinischen Bedienpersonal während einer Untersuchung weist die Magnetresonanzvorrichtung eine Kommunikationseinheit auf. Die Kommunikationseinheit weist auf Benutzerseite bevorzugt ein Kommunikationselement, wie beispielsweise eine Kommunikationskonsole zur Eingabe und/oder Ausgabe von Kommunikationsdaten, wie beispielsweise Informationen, auf. Des Weiteren weist die Kommunikationseinheit auf Patientenseite ebenfalls zumindest ein Kommunikationselement auf. Insbesondere weist die Kommunikationseinheit ein akustisches und/oder visuelles Kommunikationselement auf. Das akustische Kommunikationselement kann beispielsweise ein Lautsprecher oder ein Mikrophon sein. Das visuelle Kommunikationselement kann beispielsweise ein Bildschirm, insbesondere ein berührungsempfindlicher Bildschirm, sein.

Die Erfindung betrifft auch ein Computerprogrammprodukt mit einem Computerprogramm sowie ein computerlesbares Medium. Eine weitgehend softwaremäßige Realisierung hat den Vorteil, dass auch schon bisher verwendete zentrale Steuerungen auf einfache Weise durch ein Software-Update nachgerüstet werden können, um auf die beschriebene Weise zu arbeiten. Ein solches Computerprogrammprodukt kann neben dem Computerprogramm gegebenenfalls zusätzliche Bestandteile wie z. B. eine Dokumentation und/oder zusätzliche Komponenten, sowie Hardware-Komponenten, wie z.B. Hardware-Schlüssel (Dongles etc.) zur Nutzung der Software, umfassen.

Insbesondere betrifft die Erfindung auch ein Computerprogrammprodukt mit einem Computerprogramm, welches direkt in einen Speicher einer zentrale Steuerung ladbar ist, mit Programmabschnitten, um alle Schritte des oben beschriebenen Verfahrens zum Ermitteln eines optimalen Energiesparzustands eines MRT-Systems und seine Aspekte auszuführen, wenn die Programmabschnitte von der zentralen Steuerung ausgeführt werden.

Insbesondere betrifft die Erfindung ein computerlesbares Speichermedium, auf welchem von einer zentralen Steuerung lesbare und ausführbare Programmabschnitte gespeichert sind, um alle Schritte des oben beschriebenen Verfahrens zum Ermitteln eines optimalen Energiesparzustands eines MRT-Systems und seine Aspekte auszuführen, wenn die Programmabschnitte von der zentralen Steuerung ausgeführt werden.

Die oben beschriebenen Eigenschaften, Merkmale und Vorteile dieser Erfindung werden klarer und verständlicher im Zusammenhang mit folgenden Figuren und ihren Beschreibungen. Dabei sollen die Figuren und Beschreibungen die Erfindung und ihre Ausführungsformen in keiner Weise einschränken.

In verschiedenen Figuren sind gleiche Komponenten mit korrespondierenden Bezugszeichen versehen. Die Figuren sind in der Regel nicht maßstabsgetreu.

Es zeigen
Fig. 1 ein Ausführungsbeispiel eines Verfahrens zum Ermitteln eines optimalen Energiesparzustands eines MRT-Systems,
Fig. 2 ein Ausführungsbeispiel eines Verfahrens zum Bereitstellen einer trainierten Funktion,
Fig. 3 eine zentrale Steuerung zum Ermitteln eines optimalen Energiesparzustands eines MRT-Systems,
Fig. 4 ein Trainingssystem zum Bereitstellen einer trainierten Funktion,
Fig. 5 ein Ausführungsbeispiel eines MRT-Systems.

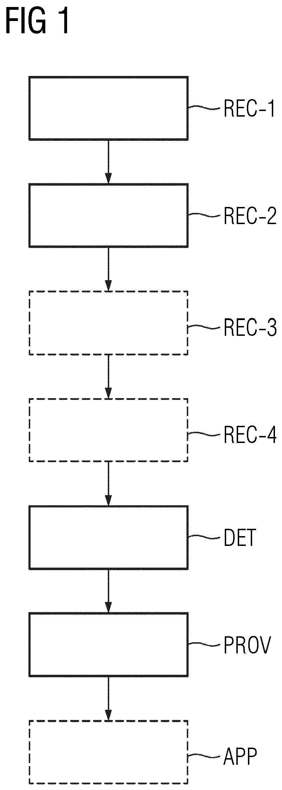

**Figur 1** zeigt ein Ausführungsbeispiel eines Verfahrens zum Ermitteln eines optimalen Energiesparzustands eines MRT-Systems 1.

In einem Verfahrensschritt eines Empfangens REC-1 eines Regelsatzes wird der Regelsatz mit einer Schnittstelle SYS.IF einer zentralen Steuerung SYS empfangen. Insbesondere kann der Regelsatz dafür von einer Datenbank bereitgestellt werden.

Das Verfahren umfasst einen weiteren Verfahrensschritt eines Empfangens REC-2 von Zuständen von Komponenten mit der Schnittstelle SYS.IF der zentralen Steuerung SYS.

Die Komponenten sind dabei Komponenten des MRT-Systems 1 und einer Umgebung des MRT-Systems 1.

Insbesondere können die Komponenten aus einer Menge von einem Patiententisch 15 des MRT-Systems 1 oder eines Rechensystem des MRT-Systems 1 oder eines Planungssystems des MRT-Systems 1 sein. Alternativ kann die Menge auch ein Notfalleingang einer Notaufnahme aus der Umgebung des MRT-Systems 1 oder ein MRT Untersuchungsraum umfassen.

Dabei ist der Patiententisch 15 des MRT-Systems 1 dazu ausgebildet, einen Patienten während einer medizinischen Bildgebung mit dem MRT-System 1 zu lagern. Der Patiententisch 15 kann dabei verschiedene Positionen einnehmen. Der Zustand des Patiententisches 15 beschreibt dabei insbesondere, welche Position der Patiententisch 15 zu diesem Zeitpunkt einnimmt. Insbesondere kann erkannt werden, wenn der Patiententisch 15 in einer Ruheposition bzw. Warteposition ist. In der Ruheposition ist kein Patient auf dem Patiententisch positioniert und wird aktuell auch nicht positioniert. Eine Ruheposition des Patiententisches 15 kann darauf hindeuten, dass das MRT-System 1 für einen bestimmten Zeitraum nicht genutzt werden wird.

Das Rechensystem ist für eine Steuerung des MRT-Systems 1 ausgebildet. Insbesondere kann eine medizinische Bildgebung mit dem MRT-System 1 mittels dem Rechensystem gesteuert werden. Der Zustand des Rechensystems beschreibt insbesondere, ob aktuell eine medizinische Bildgebung mit dem MRT-System 1 durchgeführt wird. Insbesondere kann aus dem Zustand des Rechensystems abgeleitet werden, dass das MRT-System 1 aktiv ist und nicht in einen deaktivierten Zustand, insbesondere einen Energiesparzustand versetzt werden sollte.

Das Planungssystem des MRT-Systems 1 ist insbesondere dazu ausgebildet, eine Warteschlange von Patienten, für die eine medizinische Bildgebung mit dem MRT-System 1 durchgeführt werden soll, zu erfassen. Insbesondere kann ein medizinisches Bedienpersonal eingeben, von welchem Patienten, wann mit dem MRT-System 1 eine medizinische Bildgebung durchgeführt werden soll. Alternativ oder zusätzlich kann das Planungssystem dazu ausgebildet sein, eine Protokollwarteschlange zu erfassen. Die Protokollwarteschlange gibt an, wann welches Protokoll für eine medizinische Bildgebung mit dem MRT-System 1 ausgeführt werden soll. Insbesondere kann die Protokollwarteschlange mit der Warteschlange der Patienten korreliert sein. Dabei kann jedem Patienten in der Warteschlange ein oder mehrere Protokolle in der Protokollwarteschlange zugeordnet sein. Der Zustand des Planungssystems gibt dann an, ob wenigstens ein Patient von der Warteschlange umfasst ist und/oder ob wenigstens ein Protokoll von der Protokollwarteschlange umfasst ist. Wenn wenigstens ein Patient bzw. wenigstens ein Protokoll von der Warteschlange bzw. der Protokollwarteschlange umfasst ist, kann aus dem Planungssystem abgelesen werden, wann die medizinische Bildgebung des wenigstens einen Patienten und/oder mit dem wenigstens einen Protokoll geplant ist und daraus abgeleitet werden, wann das MRT-System 1 einsatzbereit bzw. aktiv sein soll.

Der Notfalleingang kann insbesondere der Eingang einer Notfallaufnahme aus der Umgebung des MRT-Systems 1 sein. Insbesondere kann der Notfalleingang ein Eingang einer Notfallaufnahme eines Krankenhauses sein. Der Zustand des Notfalleingangs gibt an, ob sich aktuell ein Patient in der Notaufnahme befindet. Insbesondere kann der Zustand des Notfalleingangs angeben, ob ein in der Notaufnahme befindlicher Patient potentiell eine medizinische Bildgebung mit dem MRT-System 1 benötigt. Insbesondere kann aus dem Zustand des Notfalleingangs abgeleitet werden, ob das MRT-System 1 präventiv in einen aktiven Zustand bzw.

Betriebszustand oder wenigstens in einen Energiesparzustand versetzt werden sollte, aus welchem es schnell aktivierbar ist bzw. einsatzbereit ist.

Der MRT Untersuchungsraum umfasst insbesondere den MRT Raum 26, in dem eine von dem MRT-System 1 umfasste Magnetresonanzvorrichtung 10 positioniert ist. Insbesondere kann der MRT Untersuchungsraum außerdem einen Kontrollraum 27 umfassen, von welchem aus das MRT-System 1 kontrolliert bzw. gesteuert wir. Der MRT Untersuchungsraum kann dabei insbesondere ein oder mehrere Sub-Komponenten umfassen. Eine Sub-Komponente des MRT Untersuchungsraums kann beispielsweise ein Lichtschalter und/oder ein Heizungssystem sein. Der Zustand des MRT Untersuchungsraums kann dabei angeben, ob der Lichtschalter an oder aus und/oder auf welche Temperatur das Heizungssystem eingestellt ist. Aus dem Zustand des MRT Untersuchungsraums kann abgeleitet werden, ob demnächst eine medizinische Bildgebung mit dem MRT-System geplant ist. Beispielsweise kann ein Lichtschalter auf "an" darauf hinweisen, dass sich Personen in dem MRT Untersuchungsraum befinden und somit eine medizinische Bildgebung in naher Zukunft stattfinden wird. Insbesondere kann aus einer Temperatur des Heizungssystems abgeleitet werden, ob eine medizinische Bildgebung demnächst stattfindet, oder ob die Heizung beispielsweise nachts abgesenkt ist und voraussichtlich keine Untersuchung stattfindet.

Der Regelsatz umfasst dabei wenigstens eine Regel. Die Regel gibt dabei eine Abhängigkeit zwischen Zuständen der Komponenten und einem optimalen Energiesparzustand vor. Mit anderen Worten ist mittels der Regel basierend auf den Zuständen der Komponenten der optimale Energiesparzustand bestimmbar.

Der optimale Energiesparzustand ist ein Zustand des MRT-Systems 1 in welchem ein oder mehrere Komponenten deaktiviert bzw. heruntergefahren oder in einem Standby-Zustand bzw. Energiesparzustand sind. In Abhängigkeit davon, welche Komponenten des MRT-Systems deaktiviert und/oder in einem Standby-Zustand sind, kann es unterschiedlich lange dauern, bis das MRT-System 1 wieder einsatzbereit bzw. vollständig aktiv ist. Alternativ kann der optimale Energiesparzustand des MRT-Systems 1 ein Zustand sein, in welchem alle Komponenten des MRT-Systems 1 aktiv sind und das MRT-System 1 somit jederzeit sofort einsatzbereit ist. Dieser Zustand wird auch als Betriebszustand bezeichnet.

Der optimale Energiesparzustand kann in der Regel indirekt vorgegeben sein, beispielsweise durch eine maximale Aktivierungszeit. Die maximale Aktivierungszeit gibt an, innerhalb welcher Zeit das MRT-System 1 wieder einsatzbereit sein muss. Die maximale Aktivierungszeit setzt somit eine Bedingung für den optimalen Energiesparzustand. Die maximale Aktivierungszeit kann in Form einer tatsächlichen Zeitangabe angegeben sein, beispielsweise 0s, 30min, 1h, 5h etc. Alternativ kann die maximale Aktivierungszeit in Form von Kategorien angegeben sein, die beschreiben, wie schnell das MRT-System 1 einsatzbereit sein soll. Die Kategorien können beispielsweise ein Ampelsystem umfassen.

Das MRT-System umfasst dabei eine Mehrzahl an Komponenten, die deaktivierbar und/oder in einen Standby-Zustand versetzbar sind, beispielsweise einen Gradientenverstärker, einen Hochfrequenzverstärker, einen Patiententisch, einen Helium-Kompressor, ein Kühlsystem, ein Rechensystem, einen Generator für Verstimmströme, ein Planungssystem etc. Einzelne Komponenten des MRT-Systems können wiederrum Sub-Komponenten, wie beispielsweisen einen Modulator etc. umfassen. Ein Energiesparzustand des MRT-Systems 1 kann hergestellt werden, indem Komponenten oder Sub-Komponenten des MRT-Systems deaktiviert bzw. heruntergefahren und/oder in einen Standby-Zustand bzw. Energiesparzustand versetzt wird.

In einem Verfahrensschritt eines Bestimmens DET des optimalen Energiesparzustands wird basierend auf dem Regelsatz und den Zuständen der Komponenten der optimale Energiesparzustand bestimmt. Insbesondere wird dabei der optimale Energiesparzustand mittels der von dem Regelsatz umfassten wenigstens einen Regel bestimmt.

In einem von dem Verfahren umfassten Verfahrensschritt eines Bereitstellens PROV einer Information bezüglich des optimalen Energiesparzustands wird insbesondere mittels der Schnittstelle SYS.IF die Information bezüglich des optimalen Energiesparzustands bereitgestellt.

Die Information ist generisch und derart ausgebildet, dass eine entsprechende Komponente oder Sub-Komponente des MRT-Systems 1 aus dieser Information ableiten kann, ob sie in einen Energiesparzustand versetzt werden soll und wenn ja, in welchen. Beispielsweise kann die Information angeben, wie groß die Aktivierungszeit maximal sein darf. Jede einzelne Komponente kann basierend darauf selbstständig entscheiden ob und in welchen Energiesparzustand sie versetzt werden soll.

In dem Trainingsverfahren kann alternativ die Information insbesondere eine Information darüber umfassen, welche Komponenten des MRT-Systems 1 deaktiviert und/oder in einen Standby-Zustand versetzt werden sollen, und/oder welche Komponenten des MRT-Systems 1 aktiviert und/oder in einen Standby-Zustand versetzt werden sollen. Die Information kann insbesondere einer Datenbank bereitgestellt werden. Alternativ oder zusätzlich kann die Information einem Bedienpersonal bereitgestellt werden. Alternativ oder zusätzlich kann die Information den Komponenten bereitgestellt werden, sodass die entsprechenden Aktionen an den Komponenten durchgeführt werden können und die Komponenten in den entsprechenden Zustand versetzt werden können.

In einem optionalen Verfahrensschritt eines Versetzens APP des MRT-Systems 1 in den optimalen Energiesparzustand, wird basierend auf der bereitgestellten Information das MRT-System 1 in den optimalen Energiesparzustand versetzt. Insbesondere kann basierend auf der bereitgestellten Information der Komponenten des MRT-Systems 1 bzw. der von dem MRT-System 1 umfassten Komponente deaktiviert bzw. heruntergefahren und/oder in einen Standby-Zustand bzw. Energiesparzustand versetzt und/oder aktiviert werden.

Vorteilhafterweise können die Komponenten des MRT-Systems 1 basierend auf der bereitgestellten Information selbstständig entscheiden, welcher Energiesparzustand für sie optimal ist. Dafür ist die Information wie oben beschrieben generisch ausgebildet. Insbesondere kann die Information die maximale Aktivierungszeit vorgeben. Basierend darauf kann beim Versetzten des MRT-Systems 1 in den optimalen Energiesparzustand jede Komponente selbstständig bestimmen, in welchen Energiesparzustand sie sich versetzen kann, um innerhalb der maximalen Aktivierungszeit wieder einsatzbereit zu sein.

Optional umfasst das Verfahren außerdem einen Verfahrensschritt eines Empfangens REC-3 einer optionalen Nutzereingabe bezüglich des optimalen Energiesparzustands mit der Schnittstelle SYS.IF der zentralen Steuerung SYS. Die Nutzereingabe kann dabei insbesondere von einem Bedienpersonal bereitgestellt werden. Das Bedienpersonal kann dabei ein Radiologe bzw. eine Radiologin und/oder eine MRTA sein. Die Nutzereingabe kann eine einmalige Regel festlegen. Mit anderen Worten kann die Nutzereingabe zu einer einmaligen Festlegung des optimalen Energiesparzustandes ausgebildet sein. Alternativ kann die Nutzereingabe dazu ausgebildet sein, eine von dem Regelsatz umfasste Regel bezüglich den Zuständen der Komponenten dauerhaft zu ändern. Die Nutzereingabe ist dazu ausgebildet, den mittels des Regelsatzes bestimmten optimalen Energiesparzustand zu überschreiben. Die Nutzereingabe kann den alternativen optimalen Energiesparzustand beispielsweise in Form einer maximalen Aktivierungszeit vorgeben. Alternativ kann die Nutzereingabe vorgeben, welche Komponente in welchen Energiesparzustand versetzt werden soll. In dem Verfahrensschritt des Bestimmens des optimalen Energiesparzustands wird dann die Information bezüglich des mit der Nutzereingabe empfangenen optimalen Energiesparzustands bereitgestellt. Die Nutzereingabe ist dabei optional.

Optional umfasst das Verfahren außerdem einen Verfahrensschritt eines Empfangens REC-4 einer Zeitinformation mit der Schnittstelle SYS.IF der zentralen Steuerung SYS. Die Zeitinformation kann dabei insbesondere eine Uhrzeit und/oder ein Datum umfassen. Alternativ oder zusätzlich kann die Zeitinformation eine vordefinierte Zeitspanne umfassen.

Der Regelsatz umfasst dann außerdem eine Regel bezüglich der Zeitinformation. Wenn die Zeitinformation eine Uhrzeit umfasst, kann die Regel einen optimalen Energiesparzustand in Abhängigkeit der Uhrzeit vorgeben. Beispielsweise kann die Regel vorgeben, dass immer abends zu einer bestimmten Uhrzeit ein bestimmter Energiesparzustand für das MRT-System 1 optimal ist. Die Regel kann dann außerdem vorgeben, dass dann morgens ab einer bestimmten Uhrzeit ein anderer Energiesparzustand optimal ist. Auf diese Weise kann beispielsweise eine Nachtabschaltung realisiert werden, ohne dass die Zustände einzelner Komponenten analysiert werden müssen. Eine Abschaltung bedeutet, dass ein oder mehrere Komponenten des MRT-Systems 1 deaktiviert oder in einen Standby-Zustand versetzt werden. Insbesondere wird für den Zeitraum der Abschaltung ein neuer optimaler Energiesparzustand bestimmt. Wenn die Zeitinformation ein Datum umfasst, kann auf diese Weise analog eine Abschaltung beispielsweise über Wochenende oder Feiertag realisiert werden. Optional kann zusätzlich ein Schichtplan berücksichtigt werden. Zu Uhrzeiten und/oder Daten, an welchen kein Bedienpersonal in den Schichtplan eingetragen ist, kann eine oben beschriebene Abschaltung durchgeführt werden. Wenn die Zeitinformation eine vordefinierte Zeitspannt umfasst, kann beispielsweise, wenn innerhalb dieser Zeitspanne keine Änderung der Zustände der Komponenten aufgetreten ist, eine oben beschriebene Abschaltung durchgeführt werden, indem ein neuer optimaler Energiesparzustand bestimmt wird.

Beim Bestimmen DET des optimalen Energiesparzustands wird die Regel bezüglich dieser Zeitinformation berücksichtigt.

Optional kann das zuvor beschriebene Verfahren durch einen zeitlichen Trigger initiiert werden. Mit anderen Worten kann das Verfahren nach Ablauf einer vorbestimmten Zeitspanne ausgeführt wird. Mit anderen Worten kann das Verfahren regelmäßig nach Ablauf einer vorbestimmten Zeitspanne ausgeführt werden. Mit anderen Worten wird nach Ablauf der vorbestimmten Zeitspanne der Zustand der Komponenten empfangen und der optimale Energiesparzustand basierend darauf bestimmt. Insbesondere wird somit Aktualität des aktuellen optimalen Energiesparzustands nach Ablauf der vorbestimmten Zeitspanne überprüft.

Alternativ oder zusätzlich kann optional das Verfahren durch eine Zustandsänderung der Zustände der Komponenten initiiert werden. Mit anderen Worten kann eine Änderung der Zustände der Komponenten das Verfahren initiieren. Insbesondere wird der optimale Energiesparzustand bei einer Änderungen der Zustände der Komponenten erneut bestimmt bzw. angepasst.

Alternativ oder zusätzlich kann optional das Verfahren durch das Empfangen einer Nutzereingabe initiiert werden. Mit anderen Worten kann ein Bedienpersonal mittels einer Nutzereingabe ein erneutes Bestimmen des optimalen Energiesparzustands initiieren. Mit anderen Worten kann das Verfahren durch eine manuelle Eingabe bzw. manuell initiiert werden.

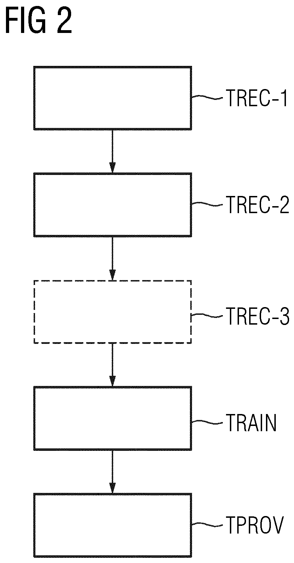

Optional kann der Regelsatz eine trainierte Funktion umfassen. Die trainierte Funktion kann dabei wie oben beschrieben ausgebildet sein. Insbesondere kann die trainierte Funktion mit dem gemäß Figur 2 beschriebenen Verfahren trainiert sein. Optional kann die trainierte Funktion kontinuierlich weiter trainiert werden. Beim Bestimmen DET des optimalen Energiesparzustands wird die trainierte Funktion auf die Zustände der Komponenten angewendet. Dabei wird der optimale Energiesparzustand bestimmt.

Optional ist die wenigstens eine Regel in Abhängigkeit einer Zugriffsberechtigung anpassbar. Insbesondere ist die wenigstens eine Regel in Abhängigkeit der Zugriffsberechtigung manuell, insbesondere durch ein Bedienpersonal und/oder durch einen Hersteller und/oder durch ein Wartungspersonal bzw. Service-Personal, anpassbar. Insbesondere kann die wenigstens eine Regel einmalig angepasst werden. Alternativ kann die wenigstens eine Regel dauerhaft angepasst werden. Die Zugriffsberechtigung regelt dabei, ob die wenigstens eine Regel angepasst werden darf. Außerdem regelt die Zugriffsberechtigung wer die wenigstens eine Regel anpassen darf. Eine nicht durch das Bedienpersonal anpassbare Regel kann in Ausführungen der Erfindung deaktivierbar sein. Mit anderen Worten kann eine solche Regel durch das Bedienpersonal in Ausführungen der Erfindung deaktivierbar sein und somit beim Bestimmen DET des optimalen Energiesparzustands nicht angewendet werden.

**Figur 2** zeigt ein Ausführungsbeispiel eines Verfahrens zum Bereitstellen einer trainierten Funktion.

Das Verfahren umfasst einen Verfahrensschritt eines Empfangens TREC-1 von Zuständen von Komponenten mit einer Trainingsschnittstelle TSYS.IF eines Trainingssystems TSYS. Die Zustände sind dabei insbesondere wie bezüglich Figur 1 beschrieben ausgebildet. Die Komponenten sind dabei insbesondere wie bezüglich Figur 1 beschrieben ausgebildet.

Das Verfahren umfasst außerdem einen Verfahrensschritt eines Empfangens TREC-2 einer Information bezüglich eines optimalen Energiesparzustands. Die Information bezüglich des optimalen Energiesparzustands ist dabei insbesondere wie bezüglich Figur 1 beschrieben ausgebildet. Die Information bezüglich des optimalen Energiesparzustands hängt dabei von den Zuständen der Komponenten ab. Insbesondere kann diese Abhängigkeit in einer von einem Regelsatz umfassten Regel, der gemäß der Beschreibung zu Figur 1 ausgebildet ist, vorgegeben sein. Alternativ kann die Information bezüglich des optimalen Energiesparzustands und der Zustände der Komponenten manuell, beispielsweise durch eine Nutzereingabe, vorgegeben werden. Insbesondere kann die Nutzereingabe die von dem Regelsatz umfasste Regel überschreiben.

Das Verfahren umfasst weiter einen Verfahrensschritt eines Trainierens TRAIN der Funktion basierend auf dem den Zuständen der Komponenten und der Information bezüglich des optimalen Energiesparzustands. Insbesondere wird dabei die Funktion iterativ mehrfach auf die Zustände der Komponenten angewendet. Dabei werden Parameter der Funktion angepasst. Dabei werden die Parameter der Funktion so lange angepasst, dass beim Anwenden der Funktion der optimale Energiesparzustand bestimmt wird. Diese derart angepasste Funktion wird als trainierte Funktion bezeichnet.

Das Verfahren umfasst außerdem einen Verfahrensschritt eines Bereitstellens TPROV der trainierten Funktion. Dabei wird die trainierte Funktion derart bereitgestellt, dass sie in dem gemäß Figur 1 beschriebenen Verfahren angewendet werden kann.

Optional kann das Trainieren TRAIN auf einem dezentralen, verteilten Training basieren. Mit anderen Worten kann die Funktion dezentral in verschiedenen Institutionen unabhängig voneinander wie oben beschrieben trainiert werden. Eine Institution kann dabei beispielsweise ein Krankenhaus oder eine Radiologiepraxis oder ein Krankenhausverbund sein. Die derart verteilt trainierten Funktionen können anschließend zentral zu einer gemeinsamen trainierten Funktion zusammengeführt werden, die in dem gemäß Figur 1 beschriebenen Verfahren zum Bestimmen DET des optimalen Energiesparzustands angewendet wird.

Optional kann die trainierte Funktion durch eine Feedback-Schleife während der Anwendung in dem Verfahren gemäß Figur 1 kontinuierlich weiter trainiert werden. Insbesondere können die Parameter in Abhängigkeit einer gemäß Figur 1 beschriebenen Nutzereingabe bezüglich des optimalen Energiesparzustands weiter angepasst werden. Insbesondere kann das Weitertrainieren gemäß dem beschriebenen Trainingsverfahren erfolgen.

Optional kann das Verfahren einen Verfahrensschritt eines Empfangens TREC-3 einer Information über einen Grad, mit dem die trainierte Funktion kontinuierlich weiter trainiert werden soll, umfassen. Dabei wird beim Trainieren TRAIN der Funktion der Grad berücksichtigt. Beispielsweise kann der Grad angeben, wie stark die Parameter basierend auf der Nutzereingabe beim kontinuierlichen Training der Funktion angepasst werden soll. Alternativ oder zusätzlich kann der Grad angeben, wie häufig dieselbe Nutzereingabe empfangen werden soll, bevor sie für das kontinuierliche Weitertrainieren berücksichtigt wird.

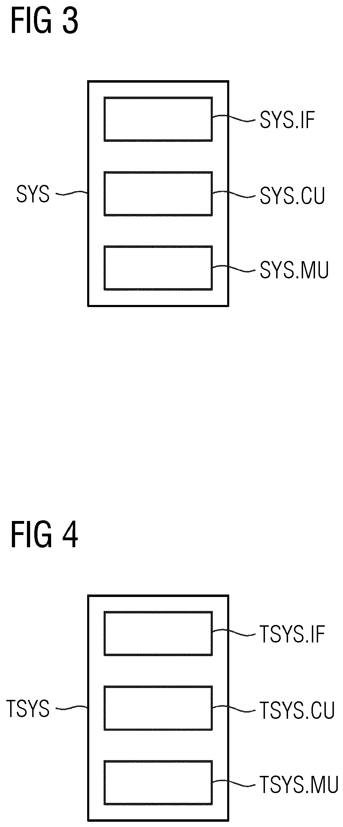

**Figur 3** zeigt eine zentrale Steuerung SYS zum Ermitteln eines optimalen Energiesparzustands eines MRT-Systems 1, **Figur 4** zeigt ein Trainingssystem TSYS zum Bereitstellen einer trainierten Funktion.

Die dargestellte zentrale Steuerung SYS zum Ermitteln eines optimalen Energiesparzustands eines MRT-Systems 1 ist dazu ausgebildet ein erfindungsgemäßes Verfahren zum Ermitteln eines optimalen Energiesparzustands eines MRT-Systems 1 auszuführen. Das dargestellte Trainingssystem TSYS ist dazu ausgebildet ein erfindungsgemäßes Verfahren zum Bereitstellen der trainierten Funktion auszuführen. Die zentrale Steuerung SYS umfasst eine Schnittstelle SYS.IF, eine Recheneinheit SYS.CU und eine Speichereinheit SYS.MU. Das Trainingssystem TSYS umfasst eine Trainingsschnittstelle TSYS.IF, eine Trainingsrecheneinheit TSYS.CU und eine Trainingsspeichereinheit TSYS.MU.

Die zentrale Steuerung SYS und/oder das Trainingssystem TSYS kann insbesondere ein Computer, ein Mikrocontroller oder ein integrierter Schaltkreis (integrated circuit, IC) sein. Alternativ kann die zentrale Steuerung SYS und/oder das Trainingssystem TSYS ein reales oder virtuelles Computer-Netzwerk sein (eine technische Bezeichnung für ein reales Computer-Netzwerk ist "Cluster", eine technische Bezeichnung für ein virtuelles Computer-Netzwerk ist "Cloud"). Die zentrale Steuerung SYS und/oder das Trainingssystem TSYS kann als virtuelles System ausgebildet sein, welches auf einem Computer oder einem realen Computer-Netzwerk oder einem virtuellen Computer-Netzwerk ausgeführt wird (eine technische Bezeichnung ist "Virtualization").

Die Schnittstelle SYS.IF und/oder die Trainingsschnittstelle TSYS.IF kann eine Hardware- oder Software-Schnittstelle sein (beispielsweise ein PCI bus, USB oder Firewire). Die Recheneinheit SYS.CU und/oder die Trainingsrecheneinheit TSYS.CU kann Hardware und/oder Software Bestandteile umfassen, beispielsweise einen Mikroprozessor oder einen sogenannten FPGA (Field Programmable Gate Way). Die Speichereinheit SYS.MU und/oder die Trainingsspeichereinheit TSYS.MU kann als nicht permanent arbeitender Arbeitsspeicher (Random Access Memory, RAM) oder als permanenter Massenspeicher (Festplatte, USB-Stick, SD-Karte, Solid State Disk (SSD)) ausgebildet sein.

Die Schnittstelle SYS.IF und/oder die Trainingsschnittstelle TSYS.IF kann insbesondere eine Mehrzahl an Sub-Schnittstellen umfassen, die unterschiedliche Verfahrensschritte des jeweiligen erfindungsgemäßen Verfahrens ausführen. Mit anderen Worten kann die Schnittstelle SYS.IF und/oder die Trainingsschnittstelle TSYS.IF als eine Mehrzahl an Schnittstellen SYS.IF und/oder Trainingsschnittstellen TSYS.IF ausgebildet sein. Die Recheneinheit SYS.CU und/oder die Trainingsrecheneinheit TSYS.CU kann insbesondere eine Mehrzahl an Sub-Recheneinheiten umfassen, die unterschiedliche Verfahrensschritte des jeweiligen erfindungsgemäßen Verfahrens ausführen. Mit anderen Worten kann die Recheneinheit SYS.CU und/oder die Trainingsrecheneinheit TSYS.CU als eine Mehrzahl an Recheneinheiten SYS.CU und/oder Trainingsrecheneinheiten TSYS.CU ausgebildet sein.

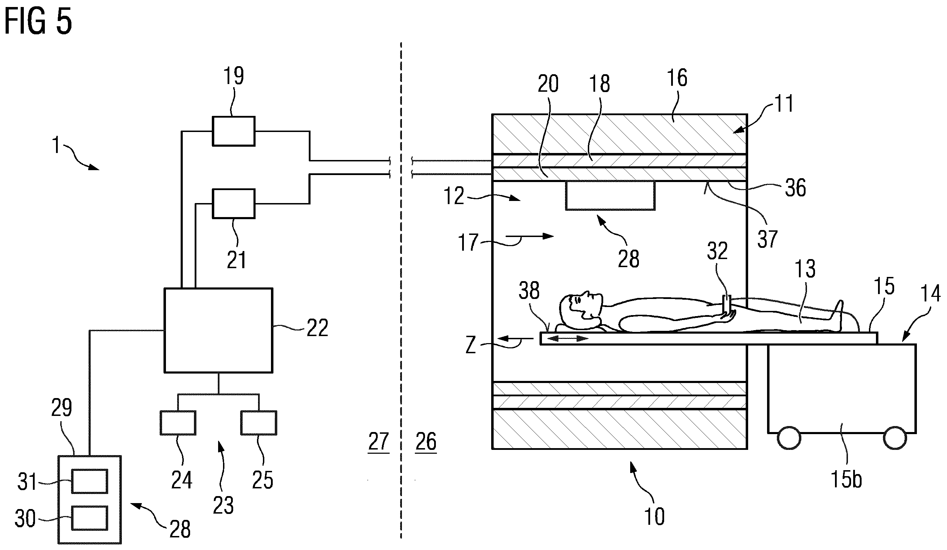

**Figur 5** zeigt ein Ausführungsbeispiel eines Magnet-Resonanz-Tomographie (Akronym: MRT) Systems 1.

Das MRT-System 1 umfasst eine Magnetresonanzvorrichtung 10. Die Magnetresonanzvorrichtung 10 umfasst eine von einer Magneteinheit gebildeten Scannereinheit 11. Zudem weist die Magnetresonanzvorrichtung 10 einen Patientenaufnahmebereich 12 auf, welcher zu einer Aufnahme eines Patienten 13 ausgebildet ist. Der Patientenaufnahmebereich 12 im vorliegenden Ausführungsbeispiel ist zylinderförmig ausgebildet und in einer Umfangsrichtung von der Scannereinheit 11, insbesondere von der Magneteinheit, zylinderförmig umgeben. Grundsätzlich ist jedoch eine davon abweichende Ausbildung des Patientenaufnahmebereichs 12 jederzeit denkbar. Der Patient 13 kann mittels einer Patientenlagerungsvorrichtung 14 des MRT-Systems 1 in den Patientenaufnahmebereich 12 geschoben und/oder gefahren werden. Die Patientenlagerungsvorrichtung 14 weist hierzu einen innerhalb des Patientenaufnahmebereichs 12 bewegbar ausgestalteten Patiententisch 15 auf. Insbesondere ist hierbei der Patiententisch 15 in Richtung einer Längserstreckung des Patientenaufnahmebereichs 12 und/oder in z-Richtung bewegbar gelagert.

Der Patientenaufnahmebereich 12 umfasst eine die den Patientenaufnahmebereich 12 umgebenden Umhausung 36 mit einer Innenwand 37. Die den Patientenaufnahmebereich 12 umgebenden Umhausung 36 ist im vorliegenden Ausführungsbeispiel einteilig mit der Hochfrequenzantenneneinheit 20, insbesondere einer dem Patientenaufnahmebereich 12 zugewandten Seite der Hochfrequenzantenneneinheit 20, ausgebildet. In einer alternativen Ausgestaltung der Erfindung kann die den Patientenaufnahmebereich 12 umgebende Umhausung 36 auch ein von der Hochfrequenzantenneneinheit 20 separaten Einheit bilden.

Die Scannereinheit 11, insbesondere die Magneteinheit, umfasst einen supraleitenden Grundmagneten 16 zum Erzeugen eines starken und insbesondere konstanten Grundmagnetfelds 17. Weiterhin weist die Scannereinheit 11, insbesondere die Magneteinheit, eine Gradientenspuleneinheit 18 zum Erzeugen von Magnetfeldgradienten auf, die für eine Ortskodierung während einer Bildgebung verwendet werden. Die Gradientenspuleneinheit 18 wird mittels einer Gradientensteuereinheit 19 des MRT-Systems 1 gesteuert. Die Scannereinheit 11, insbesondere die Magneteinheit, umfasst weiterhin eine Hochfrequenzantenneneinheit 20 zu einer Anregung einer Polarisation, die sich in dem von dem Grundmagneten 16 erzeugten Grundmagnetfeld 17 einstellt. Die Hochfrequenzantenneneinheit bzw. Körperspule (engl.: Body Coil) 20 wird von einer Hochfrequenzantennensteuereinheit 21 des MRT-Systems 1 gesteuert und strahlt hochfrequente Magnetresonanzsequenzen in den Patientenaufnahmebereich 12 der Magnetresonanzvorrichtung 10 ein.

Zu einer Steuerung des Grundmagneten16, der Gradientensteuereinheit 19 und zur Steuerung der Hochfrequenzantennensteuereinheit 21 weist das MRT-System 1 eine Systemsteuereinheit 22 auf. Die Systemsteuereinheit 22 wird von einer Recheneinheit des MRT-Systems 1 umfasst. Die Systemsteuereinheit 22 steuert zentral das MRT-System 1, wie beispielsweise das Durchführen einer vorbestimmten bildgebenden Gradientenechosequenz. Zudem umfasst die Systemsteuereinheit 22 eine nicht näher dargestellte Auswerteeinheit zu einer Auswertung von medizinischen Bilddaten bzw. MRT-Bilddaten, die während der Magnetresonanzuntersuchung bzw. Untersuchung erfasst werden.

Des Weiteren umfasst das MRT-System 1 eine Benutzerschnittstelle 23, die mit der Systemsteuereinheit 22 verbunden ist. Steuerinformationen wie beispielsweise Bildgebungsparameter, sowie rekonstruierte MRT-Bilddaten können auf einer Anzeigeeinheit 24, beispielsweise auf zumindest einem Monitor, der Benutzerschnittstelle 23 für ein medizinisches Bedienpersonal bzw. medizinisches Personal angezeigt werden. Weiterhin weist die Benutzerschnittstelle 23 eine Eingabeeinheit 25 auf, mittels der Informationen und/oder Parameter während eines Messvorgangs von dem medizinischen Bedienpersonal eingegeben werden können.

Die Scannereinheit 11 der Magnetresonanzvorrichtung 10 ist zusammen mit der Patientenlagerungsvorrichtung 14 innerhalb eines MRT Raums 26 angeordnet. Die Systemsteuereinheit 22 dagegen ist zusammen mit der Benutzerschnittstelle 23 innerhalb eines Kontrollraums 27 angeordnet. Der Kontrollraum 27 ist getrennt von dem MRT Raum 26 ausgebildet. Insbesondere ist der MRT Raum 26 hinsichtlich einer Hochfrequenzstrahlung von dem Kontrollraum 27 abgeschirmt. Während einer Untersuchung befindet sich der Patient 13 innerhalb des MRT Raums 26, dagegen befindet sich das medizinische Bedienpersonal zumeist innerhalb des Kontrollraums 27. Während einer vorbereitenden Lagerung des Patienten 13 auf dem Patiententisch 15 befindet sich das Bedienpersonal typischerweise im MRT Raum 26. Der MRT Raum 26 und der Kontrollraum 27 in Kombination bilden den MRT Untersuchungsraum.

Für eine Kommunikation und/oder eines Informationsaustauschs des Patienten 13 mit dem medizinischen Bedienpersonal während einer Untersuchung weist das MRT-System 1 eine Kommunikationseinheit 28 auf. Die Kommunikationseinheit 28 weist auf Bedienerseite eine als Bedienerkonsole 29 ausgebildetes Kommunikationselement auf. Das Kommunikationselement, insbesondere die Bedienerkonsole 28, ist bevorzugt innerhalb des Kontrollraums 27 angeordnet. Die Bedienerkonsole 29 weist ein Eingabeelement 30 und ein Ausgabeelement 31 auf. Das Eingabeelement 30 und/oder das Ausgabeelement 31 kann dabei als akustisches und/oder visuelles Eingabeelement 30 und/oder Ausgabeelement 31 ausgebildet sein.

Des Weiteren weist die Kommunikationseinheit 28 auf Patientenseite ein erstes Kommunikationselement auf, das als Eingabeelement 32 ausgebildet ist. Mittels des Eingabeelements 32 kann der Patient 13 dem Bediener, insbesondere dem medizinischen Bedienpersonal, ein Befinden, wie beispielsweise ein Unwohlsein, während der Untersuchung mitteilen. Im vorliegenden Ausführungsbeispiel ist das Eingabeelement 32 als Patientenrufball bzw. Alarmball ausgebildet. Grundsätzlich sind jedoch weitere, dem Fachmann als sinnvoll erscheinende Eingabeelemente 32, wie beispielsweise ein Mikrofon usw. in einer weiteren Ausbildung der Kommunikationseinheit 28 möglich.

Das dargestellten MRT-System 1 kann selbstverständlich weitere Komponenten umfassen, die MRT-Systeme 1 gewöhnlich aufweisen. Eine allgemeine Funktionsweise eines MRT-Systems 1 ist zudem dem Fachmann bekannt, so dass auf eine detaillierte Beschreibung der weiteren Komponenten verzichtet wird.

Wo noch nicht explizit geschehen, jedoch sinnvoll und im Sinne der Erfindung, können einzelne Ausführungsbeispiele, einzelne ihrer Teilaspekte oder Merkmale miteinander kombiniert bzw. ausgetauscht werden, ohne den Rahmen der hiesigen Erfindung zu verlassen. Mit Bezug zu einem Ausführungsbeispiel beschriebene Vorteile der Erfindung treffen ohne explizite Nennung, wo übertragbar, auch auf andere Ausführungsbeispiele zu.

## Patentansprüche

1. Computerimplementiertes Verfahren zum Ermitteln eines optimalen Energiesparzustands eines Magnet-Resonanz-Tomographie Systems umfassend folgende Verfahrensschritte:
- Empfangen (REC-1) eines Regelsatzes mit einer zentralen Steuerung,
- Empfangen (REC-2) von Zuständen von Komponenten mit der zentralen Steuerung,
wobei die Komponenten Komponenten des Magnet-Resonanz-Tomographie Systems und/oder einer Umgebung des Magnet-Resonanz-Tomographie Systems sind,
wobei der Regelsatz wenigstens eine Regel umfasst, mittels welcher basierend auf Zuständen der Komponenten der optimale Energiesparzustand bestimmbar ist,
wobei der Regelsatz dabei wenigstens eine Regel umfasst, die eine Abhängigkeit zwischen den Zuständen der Komponenten und einem optimalen Energiesparzustand vorgibt,
wobei der optimale Energiesparzustand ein Zustand des MRT-Systems (1) ist, in welchem ein oder mehrere Komponenten deaktiviert bzw. heruntergefahren oder in einem Standby-Zustand bzw. Energiesparzustand sind;
- Bestimmen (DET) des optimalen Energiesparzustands basierend auf dem Regelsatz und den Zuständen der Komponenten,
- Bereitstellen (PROV) einer Information bezüglich des optimalen Energiesparzustands,
**dadurch gekennzeichnet, dass**
die Information derart bereitgestellt wird, dass die jeweiligen Komponenten daraus ihren spezifischen optimalen Energiesparzustand ableiten, und die Information dabei generisch ist und von jeder der Komponenten lesbar ist, wobei Zustände mehrerer Komponenten des MRT-Systems und/oder aus der Umgebung des MRT-Systems berücksichtigt werden.

2. Verfahren nach Anspruch 1,
- Versetzen (APP) des Magnet-Resonanz-Tomographie Systems in den optimalen Energiesparzustand basierend auf der bereitgestellten Information bezüglich des optimalen Energiesparzustands.

3. Verfahren nach einem der vorhergehenden Ansprüche,
wobei das Verfahren durch einen zeitlichen Trigger initiiert wird und/oder
wobei das Verfahren durch eine Zustandsänderung eines Zustands einer Komponente initiiert wird und/oder
wobei das Verfahren durch Empfangen einer Nutzereingabe initiiert wird.

4. Verfahren nach einem der vorhergehenden Ansprüche,
wobei die Regel in Abhängigkeit einer Zugriffsberechtigung anpassbar ist.

5. Verfahren nach einem der vorhergehenden Ansprüche, außerdem umfassend folgenden Verfahrensschritt:
- Empfangen (REC-3) einer optionalen Nutzereingabe bezüglich des optimalen Energiesparzustands mit der zentralen Steuerung,
wobei beim Bereitstellen der Information zu dem optimalen Energiesparzustand die Information bezüglich dem mittels der Nutzereingabe bereitgestellten optimalen Energiesparzustand bereitgestellt wird, sofern eine Nutzereingabe empfangen wurde.

6. Verfahren nach einem der vorhergehenden Ansprüche, außerdem umfassend folgenden Verfahrensschritt:
- Empfangen (REC-4) einer Zeitinformation mit der zentralen Steuerung,
wobei der Regelsatz außerdem eine Regel bezüglich der Zeitinformation umfasst,
wobei beim Bestimmen (DET) des optimalen Energiesparzustands die Regel bezüglich der Zeitinformation berücksichtigt wird.

7. Verfahren nach einem der vorhergehenden Ansprüche,
wobei der Regelsatz eine trainierte Funktion umfasst,
wobei beim Bestimmen (DET) des optimalen Energiesparzustands die trainierte Funktion auf einen Zustand einer Komponente angewendet wird,
wobei der optimale Energiesparzustand bestimmt wird.

8. Verfahren nach einem der vorhergehenden Ansprüche,
wobei die Komponenten aus der Menge der folgenden Komponenten stammen:
ein Patiententisch, ein Rechensystem des Magnet-Resonanz-Tomographie Systems, ein Planungssystem, ein Notfalleingang, ein Magnet-Resonanz-Tomographie Untersuchungsraum.

9. Magnet-Resonanz-Tomographie System umfassend eine zentrale Steuerung (SYS) zum Ermitteln eines optimalen Energiesparzustands eines Magnet-Resonanz-Tomographie Systems umfassend eine Schnittstelle (SYS.IF) und eine Recheneinheit (SYS.CU),
wobei die Schnittstelle (SYS.IF) und die Recheneinheit (SYS.CU) zum Ausführen der folgenden Verfahrensschritte ausgebildet sind:
- Empfangen (REC-1) eines Regelsatzes,
- Empfangen (REC-2) von Zuständen von Komponenten,
wobei die Komponenten Komponenten des Magnet-Resonanz-Tomographie Systems sind,
wobei der Regelsatz wenigstens eine Regel umfasst, mittels welcher basierend auf den Zuständen der Komponenten ein optimaler Energiesparzustand bestimmbar ist,
wobei der Regelsatz dabei wenigstens eine Regel umfasst, die eine Abhängigkeit zwischen den Zuständen der Komponenten und einem optimalen Energiesparzustand vorgibt,
wobei der optimale Energiesparzustand ein Zustand des MRT-Systems (1) ist, in welchem ein oder mehrere Komponenten deaktiviert bzw. heruntergefahren oder in einem Standby-Zustand bzw. Energiesparzustand sind;
- Bestimmen (DET) des optimalen Energiesparzustands basierend auf dem Regelsatz und den Zuständen der Komponenten,
- Bereitstellen (PROV) einer Information bezüglich des optimalen Energiesparzustands,
**dadurch gekennzeichnet, dass**
die Information derart bereitgestellt wird, dass die jeweiligen Komponenten ausgebildet sind, daraus ihren spezifischen optimalen Energiesparzustand abzuleiten und die Information dabei generisch ist und von jeder der Komponenten lesbar ist,
wobei Zustände mehrerer Komponenten des MRT-Systems berücksichtigt werden.

10. Computerprogrammprodukt mit einem Computerprogramm, welches direkt in einen Speicher (SYS.MU) einer zentralen Steuerung(SYS) ladbar ist, mit Programmabschnitten, um alle Schritte des Verfahrens nach einem der Ansprüche 1 bis 8 auszuführen, wenn die Programmabschnitte von der zentralen Steuerung (SYS) ausgeführt werden

11. Computerlesbares Speichermedium, auf welchem von einer zentralen Steuerung (SYS) lesbare und ausführbare Programmabschnitte gespeichert sind, um alle Schritte des Verfahrens nach einem der Ansprüche 1 bis 8 auszuführen, wenn die Programmabschnitte von der zentralen Steuerung (SYS) ausgeführt werden.

## Claims

1. Computer-implemented method for ascertaining an optimal energy-saving state of a magnetic resonance imaging system, comprising the following method steps:
- receiving (REC-1) a set of rules with a central controller,
- receiving (REC-2) states of components with the central controller,
wherein the components are components of the magnetic resonance imaging system and/or an environment of the magnetic resonance imaging system,
wherein the set of rules comprises at least one rule by means of which the optimal energy-saving state can be determined based on states of the components,
wherein the set of rules herein comprises at least one rule, which specifies a dependency between the states of the components and an optimal energy-saving state,
wherein the optimal energy-saving state is a state of the MRI system (1), in which one or more components are deactivated or shut down or in a standby state or energy-saving state;
- determining (DET) the optimal energy-saving state based on the set of rules and the states of the components,
- providing (PROV) information regarding the optimal energy-saving state,
**characterised in that**
the information is provided in such a way that the respective components can deduce their specific optimal energy-saving state therefrom and the information herein is generic and can be read by each of the components, wherein states of multiple components of the MRI system and/or from the environment of the MRI system are taken into account.

2. Method according to claim 1,
- setting (APP) the magnetic resonance imaging system to the optimal energy-saving state based on the information provided regarding the optimal energy-saving state.

3. Method according to one of the preceding claims,
wherein the method is initiated by a time trigger and/or
wherein the method is initiated by a change in the state of a state of a component and/or
wherein the method is initiated by receiving a user input.

4. Method according to one of the preceding claims,
wherein the rule can be adapted in dependence on access authorization.

5. Method according to one of the preceding claims,
also comprising the following method step:
- receiving (REC-3) an optional user input regarding the optimal energy-saving state with the central controller,
wherein, when providing the information on the optimal energy-saving state, the information regarding the optimal energy-saving state provided by means of the user input is provided if user input has been received.

6. Method according to one of the preceding claims,
also comprising the following method step:
- receiving (REC-4) time information with the central controller,
wherein the set of rules also comprises a rule relating to the time information,
wherein the rule relating to the time information is taken into account when determining (DET) the optimal energy-saving state.

7. Method according to one of the preceding claims,
wherein the set of rules comprises a trained function, wherein, when determining (DET) the optimal energy-saving state, the trained function is applied to a state of a component,
wherein the optimal energy-saving state is determined.

8. Method according to one of the preceding claims,
wherein the components originate from the quantity of the following components:
a patient table, a computing system of the magnetic resonance imaging system, a planning system, an emergency entrance, a magnetic resonance imaging examination room.

9. Magnetic resonance imaging system comprising a central controller (SYS) for ascertaining an optimal energy-saving state of a magnetic resonance imaging system comprising an interface (SYS.IF) and a computing unit (SYS.CU),
wherein the interface (SYS.IF) and the computing unit (SYS.CU) are embodied to execute the following method steps:
- receiving (REC-1) a set of rules,
- receiving (REC-2) states of components,
wherein the components are components of the magnetic resonance imaging system,
wherein the set of rules comprises at least one rule by means of which an optimal energy-saving state can be determined based on the states of the components,
wherein the set of rules herein comprises at least one rule which specifies a dependency between the states of the components and an optimal energy saving state,
wherein the optimal energy saving state is a state of the MRI system (1), in which one or more components are deactivated or shut down or in a standby state or energy-saving state;
- determining (DET) the optimal energy-saving state based on the set of rules and the states of the components,
- providing (PROV) information regarding the optimal energy-saving state,
**characterised in that**
the information is provided in such a way that the respective components are embodied to deduce their specific optimal energy-saving state therefrom and the information herein is generic and can be read by each of the components, wherein states of multiple components of the MRI system are taken into account

10. Computer program product with a computer program which can be loaded directly into a memory (SYS.MU) of a central controller (SYS), with program sections for executing all the steps of the method according to one of claims 1 to 8 when the program sections are executed by the central controller (SYS).

11. Computer-readable storage medium on which program sections that are readable and executable by a central controller (SYS) are stored for executing all the steps of the method according to one of claims 1 to 8 when the program sections are executed by the central controller (SYS).

## Revendications

1. Procédé mis en œuvre par ordinateur de détermination d'un état optimal d'économie d'énergie d'un système de tomodensitométrie par résonnance magnétique comprenant les stades de procédé suivants :
- réception (REC-1) d'un ensemble de règles par une commande centrale,
- réception (REC-2) d'états de composants par la commande centrale,
dans lequel les composants sont des composants du système de tomodensitométrie par résonnance magnétique et/ou d'un environnement du système de tomodensitométrie par résonnance magnétique,
dans lequel l'ensemble de règles comprend au moins une règle au moyen de laquelle on peut, sur la base des états des composants, déterminer l'état optimal d'économie d'énergie,
dans lequel l'ensemble de règles comprend, à cet effet, au moins une règle, qui prescrit une dépendance entre les états des composants et un état optimal d'économie d'énergie,
dans lequel l'état optimal d'économie d'énergie est un état du système (1) de tomodensitométrie par résonnance magnétique, dans lequel un ou plusieurs composants sont désactivés ou mis en veilleuse ou dans un état d'attente ou un état d'économie d'énergie ;
- détermination (DET) de l'état optimal d'économie d'énergie sur la base de l'ensemble de règles et des états des composants,
- mise (PROV) à disposition d'une information se rapportant à l'état optimal d'économie d'énergie,
**caractérisé en ce que**
l'on met à disposition l'information, de manière à ce que les composants respectifs soient constitués pour en déduire leur état spécifique optimal d'économie d'énergie et l'information est, à cet effet, générique et peut être lue par chacun des composants, dans lequel on prend en compte des états de plusieurs composants du système de tomodensitométrie par résonnance magnétique et/ou de l'environnement du système par tomodensitométrie par résonnance magnétique.

2. Procédé suivant la revendication 1,
- mise (APP) du système de tomodensitométrie par résonnance magnétique dans l'état optimal d'économie d'énergie sur la base de l'information mise à disposition se rapportant à l'état optimal d'économie d'énergie.

3. Procédé suivant l'une des revendications précédentes,
dans lequel on lance le procédé par un déclencheur temporel et/ou dans lequel on lance le procédé par une modification d'un état d'un composant et/ou
dans lequel on lance le procédé par réception d'une entrée d'utilisateur.

4. Procédé suivant l'une des revendications précédentes,
dans lequel la règle peut être adaptée en fonction d'une autorisation d'accès.

5. Procédé suivant l'une des revendications précédentes, comprenant en outre le stade de procédé suivant :
- réception (REC-3) d'une entrée facultative d'utilisateur se rapportant à l'état optimal d'économie d'énergie par la commande centrale,
dans lequel, lors de la mise à disposition de l'information se rapportant à l'état optimal d'économie d'énergie, on met à disposition l'information se rapportant à l'état optimal
d'économie d'énergie mise à disposition à l'entrée d'utilisateur pour autant qu'une entrée d'utilisateur a été reçue.

6. Procédé suivant l'une des revendications précédentes, comprenant en outre le stade de procédé suivant :
- réception (REC-4) d'une information temporelle par la commande centrale,
dans lequel l'ensemble de règles comprend en outre une règle se rapportant à l'information temporelle,
dans lequel, lors de la détermination (DET) de l'état optimal d'économie d'énergie, on tient compte de la règle se rapportant à l'information temporelle.

7. Procédé suivant l'une des revendications précédentes,
dans lequel l'ensemble de règles comprend une fonction entraînée, dans lequel, lors de la détermination (DET) de l'état optimal d'économie d'énergie, on applique la fonction entraînée à un état d'un composant,
dans lequel on détermine l'état optimal d'économie d'énergie.

8. Procédé suivant l'une des revendications précédentes,
dans lequel les composants proviennent de l'ensemble des composants suivants :
une table de patient, un système informatique du système de tomodensitométrie par résonnance magnétique, un système de planification, une entrée d'urgence, un espace d'examen de tomodensitométrie par résonnance magnétique.

9. Système de tomodensitométrie par résonnance magnétique comprenant une commande (SYS) centrale de détermination d'un état optimal d'économie d'énergie d'un système de tomodensitométrie par résonnance magnétique comprenant une interface (SYS.IF) et une unité (SYS.CU) informatique,
dans lequel l'interface (SYS.IF) et l'unité (SYS.CU) informatique sont constituées pour l'exécution des stades de procédé suivants :
- réception (REC-1) d'un ensemble de règles,
- réception (REC-2) d'états de composants,
dans lequel les composants sont des composants du système de tomodensitométrie par résonnance magnétique et/ou d'un environnement du système de tomodensitométrie par résonnance magnétique,
dans lequel l'ensemble de règles comprend au moins une règle au moyen de laquelle on peut, sur la base des états des composants, déterminer l'état optimal d'économie d'énergie,
dans lequel l'ensemble de règles comprend, à cet effet, au moins une règle, qui prescrit une dépendance entre les états des composants et un état optimal d'économie d'énergie,
dans lequel l'état optimal d'économie d'énergie est un état du système (1) de tomodensitométrie par résonnance magnétique, dans lequel un ou plusieurs composants sont désactivés ou mis en veilleuse ou dans un état d'attente ou un état d'économie d'énergie ;
- détermination (DET) de l'état optimal d'économie d'énergie sur la base de l'ensemble de règles et des états des composants,
- mise (PROV) à disposition d'une information se rapportant à l'état optimal d'économie d'énergie,
**caractérisé en ce que**
l'on met à disposition l'information, de manière à ce que les composants respectifs soient constitués pour en déduire leur état spécifique optimal d'économie d'énergie et l'information est, à cet effet, générique et peut être lue par chacun des composants, dans lequel on prend en compte des états de plusieurs composants du système de tomodensitométrie par résonnance.

10. Produit de programme d'ordinateur, comprenant un programme d'ordinateur, qui peut être chargé directement dans la mémoire (SYS.MU) d'une commande (SYS) centrale, comprenant des parties de
programme pour exécuter tous les stades du procédé suivant l'une des revendications 1 à 8, lorsque les parties de programme sont exécutées par la commande (SYS) centrale.

11. Support de mémoire, déchiffrable par ordinateur, sur lequel sont mises en mémoire des parties de programme déchiffrables et exécutables par une commande (SYS) centrale, afin d'exécuter tous les stades du procédé suivant l'une des revendications 1 à 8, lorsque les parties de programme sont exécutées par la commande (SYS) centrale.
